# EUROPEAN PATENT APPLICATION

(11) **EP 4 614 999 A1**
(43) Date of publication of application: **10.09.2025**
(21) Application number: 23937318.6
(22) Date of filing: 20.12.2023
(51) Int. Cl.: H04R 1/10

(54) **ELECTRONIC DEVICE**

(30) Priority: 12.05.2023 CN 202310541798
(71) Applicant: Shenzhen Shokz Co., Ltd., Shenzhen, Guangdong 518108 (CN)
(72) Inventor: XIE, Shuailin, Shenzhen, Guangdong 518108 (CN); ZHU, Guangyuan, Shenzhen, Guangdong 518108 (CN); ZHANG, Lei, Shenzhen, Guangdong 518108 (CN); XIE, Zhao, Shenzhen, Guangdong 518108 (CN); LI, Yongjian, Shenzhen, Guangdong 518108 (CN); LI, Chaowu, Shenzhen, Guangdong 518108 (CN); LIU, Chunjian, Shenzhen, Guangdong 518108 (CN); TONG, Peigeng, Shenzhen, Guangdong 518108 (CN); GUO, Burui, Shenzhen, Guangdong 518108 (CN); ZHANG, Sifu, Shenzhen, Guangdong 518108 (CN)
(74) Representative: Wang, Bo
(86) International application number: PCT/CN2023/140250
(87) International publication number: WO 2024/234647

(57) **Abstract**

An electronic device, comprising a case assembly (10) and a microphone assembly (13). The case assembly (10) is provided with an accommodating cavity (1001), and two sound inlet holes (1082) are provided on the case assembly (10); the microphone assembly (13) is arranged in the accommodating cavity (1001), and the microphone assembly (13) is used for collecting an external sound inputted by means of the sound inlet holes (1082); sound inlet ends of the two sound inlet holes (1082) are spaced apart from each other, and sound outlet ends of the two sound inlet holes (1082) are communicated with each other; the microphone assembly (13) comprises a support base (131) and a microphone (132); a sound guide channel (1311) is provided on the support base (131), a sound inlet end of the sound guide channel (1311) is communicated with the sound outlet ends of the two sound inlet holes (1082), and the microphone (132) is provided at a sound outlet end of the sound guide channel (1311). **In** this way, the pickup effect of an electronic device can be improved.

## Description

The present application claims priority to Chinese Patent Application No. 202310541798.X, entitled Earphones, filed on May 12, 2023, the entire contents of which are incorporated herein by reference.

### TECHNICAL FIELD

The present application relates to the technical field of electronic devices, and in particular, to electronic devices.

### BACKGROUND

As electronic devices continue to become more widespread, they have become essential tools for communication and entertainment in our daily lives. With this growing dependence, people's expectations for these devices have also risen. Devices such as smartphones, computers, tablets, and earphones have become integral parts of our lives, greatly enriching user's experiences and enhancing the convenience of modern living.

Currently, most electronic devices are equipped with communication or sound collection capabilities. However, when these devices capture sound, they are often susceptible to wind noise, which can lead to a decrease in sound pickup effect.

### SUMMARY

The present disclosure provides an electronic device to improve the sound pickup effect of the electronic device.

To solve the above problems, the present disclosure proposes an electronic device, comprising a shell assembly, the shell assembly being provided with an accommodation cavity and two sound inlet holes; a microphone assembly accommodated in the accommodation cavity, the microphone assembly being configured to capture external sound input via the sound inlet holes; and sound inlet ends of the two sound inlet holes being spaced apart from each other and sound outlet ends of the two sound inlet holes being in communication with each other, the microphone assembly including a support base and a microphone, the support base being provided with a sound guiding channel, a sound inlet end of the sound guiding channel being in communication with the sound outlet ends of the two sound inlet holes, and the microphone being provided at a sound outlet end of the sound guiding channel.

Through the above design, sound can enter the microphone assembly inside the accommodation cavity via the two sound outlet holes, thereby enhancing the sound pickup performance of the microphone assembly. Additionally, during the sound pickup process, there may be a significant airflow entering the sound outlet holes, where the airflow may enter the shell assembly through one of the sound outlet holes and exit the shell assembly through the other sound outlet hole, which helps to slow down the airflow speed and reduce the likelihood of the airflow impacting the microphone via the sound guiding channel, thereby reducing wind noise during the sound pickup process.

In some embodiments, the sound guiding channel is provided in a bent shape.

In some embodiments, a length of the sound guiding channel is greater than or equal to 3 mm and less than or equal to 20 mm.

In some embodiments, the shell assembly is provided with a support surface and an abutting surface, the sound outlet ends of the sound inlet holes are on the abutting surface, and the support base is provided with a bottom surface and a top surface that are arranged opposite to each other and at least two side surfaces connected between the bottom surface and the top surface, the bottom surface of the support base is supported on the support surface, a predetermined side surface among the at least two side surfaces abuts against the abutting surface, the sound inlet end of the sound guiding channel is located on the predetermined side surface, the sound outlet end of the sound guiding channel is located on the top surface, the sound guiding channel is configured to further extend inclinedly towards the top surface after extending inclinedly from the predetermined side surface towards the bottom surface.

In some embodiments, the abutting surface and/or the predetermined side surface is provided with two first adhesive-accommodation grooves spaced apart from each other, the two first adhesive-accommodation grooves connect the top surface to the bottom surface of the support base, the sound outlet ends of the sound inlet holes and the sound inlet end of the sound guiding channel are located between the two first adhesive-accommodation grooves, the electronic device further comprises a first sealant, a second sealant and a third sealant, the first sealant seals the two first adhesive-accommodation grooves, the second sealant at least seals a gap between the top surface and the abutting surface located between the two first adhesive-accommodation grooves, and the third sealant seals a gap between the support surface and other side surfaces among the at least two side surfaces other than the predetermined side surface.

In some embodiments, a junction between the predetermined side surface and the top surface is provided as a beveled connection, and the junction further fits with the abutting surface to form a second adhesive-accommodation groove, the second adhesive-accommodation groove connects the two first adhesive-accommodation grooves, and the second sealant seals the second adhesive-accommodation groove.

In some embodiments, the shell assembly further includes a convex rib disposed around a periphery of the other side surfaces among the at least two side surfaces other than the predetermined side surface and protruding from the support surface, the convex rib fits with the other side surfaces among the at least two side surfaces other than the predetermined side surface to form a third adhesive-accommodation groove, and the third sealant seals the third adhesive-accommodation groove.

In some embodiments, the shell assembly includes a first shell and a second shell, the support surface and the abutting surface are located on the first shell, and the first shell is provided with a support flange, the support flange is configured to support the second shell, and the support flange is provided with a notch, and on a side proximate to the abutting surface, a portion of the support base is embedded in the notch and supports the second shell together with the support flange.

In some embodiments, the first shell is further provided with a first adhesive-bearing surface connected to the abutting surface, the first adhesive-bearing surface intersects with the abutting surface, the support base is further provided with a second adhesive-bearing surface connected to the predetermined side surface, the second adhesive-bearing surface intersects with the predetermined side surface, the first adhesive-bearing surface and the second adhesive-bearing surface are at least partially overlapped, and the electronic device further comprises a fourth sealant, the fourth sealant seals a gap between the first adhesive-bearing surface and the second adhesive-bearing surface.

In some embodiments, the support surface includes a third adhesive-bearing surface, the bottom surface includes a fourth adhesive-bearing surface, the third adhesive-bearing surface and the fourth adhesive-bearing surface are at least partially overlapped, the electronic device further includes a fifth sealant, and the fifth sealant seals a gap between the third adhesive-bearing surface and the fourth adhesive-bearing surface.

In some embodiments, the electronic device further comprises a sealing ring, and the sealing ring is elastically sandwiched between the abutting surface and the predetermined side surface, the sealing ring is disposed around an outer periphery of the sound outlet ends of the sound inlet holes and the sound inlet end of the sound guiding channel.

In some embodiments, the abutting surface is provided with a recessed region surrounding the sound outlet ends of the sound inlet holes, and the sealing ring is located in the recessed region; or the predetermined side surface is provided with a recessed region surrounding the sound inlet end of the sound guiding channel, and the sealing ring is located in the recessed region.

In some embodiments, the top surface is provided with a positioning groove, the sound outlet end of the sound guiding channel is located in the positioning groove, and the microphone is positioned in the positioning groove.

In some embodiments, the electronic device is an earphone and includes a wearing assembly, the wearing assembly is connected to the shell assembly, and in a wearing state, the wearing assembly is hung on an ear of a user and the shell assembly is positioned to be in contact with the face of the user, the sound inlet ends of the sound inlet holes are located on a side of the shell assembly along a vertical axis of the user towards the top of the user's head, and is blocked by the shell assembly or the wearing assembly along a sagittal axis of the user.

In some embodiments, the shell assembly includes the first shell, the first shell is provided with a first matching portion, the wearing assembly is provided with a second matching portion, the first matching portion is mated and connected with the second matching portion, the sound inlet holes are provided on the first shell, the first matching portion and/or the second matching portion protrudes from the sound inlet ends of the sound inlet holes along the vertical axis, the sound inlet ends of the sound inlet holes are located on a side of the first matching portion and/or the second matching portion towards the back of the user's head along the sagittal axis.

In some embodiments, a spacing distance between the sound inlet ends of the sound inlet holes along the sagittal axis and the first matching portion and/or the second matching portion is less than or equal to one-half of a maximum dimension of the first shell along the sagittal axis.

In some embodiments, a spacing distance between the sound inlet ends of the sound inlet holes and the first matching portion and/or the second matching portion along the sagittal axis is less than or equal to 5 mm.

In some embodiments, the sound inlet ends of the two sound inlet holes are spaced apart along the sagittal axis.

In some embodiments, a ratio of a spacing distance between the sound inlet ends of the two sound inlet holes to an aperture of the two sound inlet holes is in a range of 0.5 and 3.

In some embodiments, on the sagittal axis, the sound guiding channel further includes an extension component towards a front side of the user.

In some embodiments, the support base is fixed to the shell assembly by laser welding.

In some embodiments, the electronic device further comprises a tuning mesh assembly, wherein the tuning mesh assembly is located in front of the microphone in a sound pickup path from the sound inlet holes to the microphone; the tuning mesh assembly includes at least two tuning elements, each of the at least two tuning elements is located between the shell assembly and the support base, or located in front of the sound inlet ends of the sound inlet holes, or located between the support base and the microphone, or located in the sound guiding channel, or located in the sound inlet holes.

### BRIEF DESCRIPTION OF THE DRAWINGS

To more clearly illustrate the technical solutions in the embodiments of the present disclosure, the accompanying drawings that need to be used in the description of the embodiments will be briefly introduced in the following, and it will be obvious that the accompanying drawings in the following description are only some of the embodiments of the present disclosure, and other attachments can be obtained according to them without creative labor to a person of ordinary skill in the art.
FIG. 1 is a schematic diagram illustrating a 3D structure of a general assembly of an earphone according to some embodiments of the present disclosure;
FIG. 2 is a schematic diagram illustrating a 3D structure of a portion between a core assembly and a wearing assembly shown in FIG. 1;
FIG. 3 is an exploded structural diagram of the core assembly shown in FIG. 2;
FIG. 4 is a schematic diagram illustrating a sectional structure of the core assembly shown in FIG. 2 along A-A;
FIG. 5 is a schematic diagram illustrating a sectional structure of the core assembly shown in FIG. 2 along B-B;
FIG. 6 is a schematic diagram illustrating a 3D structure of a bone-conducting loudspeaker shown in FIG. 3;
FIG. 7 is an exploded schematic diagram of a bone-conducting loudspeaker shown in FIG. 3;
FIG. 8 is a schematic diagram illustrating a sectional structure of the bone-conducting loudspeaker shown in FIG. 6 along C-C;
FIG. 9a is a schematic diagram illustrating sound signals in a first frequency band and a second frequency band in the earphone shown in FIG. 1;
FIG. 9b is a schematic diagram illustrating frequencies of electrical signals input to a bone-conducting loudspeaker and an air-conducting loudspeaker of the earphone shown in FIG. 1 in a first operation mode;
FIG. 10a is a schematic diagram illustrating an exemplary structure of a detachable solution for a bone-conducting loudspeaker and an air-conducting loudspeaker of the earphone shown in FIG. 1;
FIG. 10b is a schematic diagram illustrating an exemplary structure of the bone-conducting loudspeaker and the air-conducting loudspeaker shown in FIG. 10a;
FIG. 11 is a schematic diagram illustrating a 3D structure of an air-conducting loudspeaker shown in FIG. 3;
FIG.12 is an exploded schematic diagram of the air-conducting loudspeaker shown in FIG. 11;
FIG. 13 is a schematic diagram illustrating a vibration transmission sheet shown in FIG. 7 from a front view;
FIG. 14 is a schematic diagram illustrating a portion of a sectional structure of the bone-conducting loudspeaker shown in FIG. 8;
FIG. 15 is a schematic diagram illustrating an exemplary structure of an annular fixing portion of the vibration transmission sheet shown in FIG. 13;
FIG. 16 is a schematic diagram illustrating an exemplary structure of a linkage assembly of the vibration transmission sheet shown in FIG. 13 connected to a central fixing portion;
FIG.17 is another schematic diagram illustrating a disassembled structure of the core assembly shown in FIG. 2;
FIG. 18 is a schematic diagram illustrating an exemplary structure of a bone-conducting loudspeaker shown in FIG. 17;
FIG. 19 is a schematic diagram illustrating a portion of a disassembled structure of the core assembly shown in FIG. 17;
FIG. 20 is a schematic diagram illustrating another sectional structure of the core assembly shown in FIG. 2 along B-B;
FIG. 21 is a schematic diagram illustrating an enlarged structure of an F-region shown in FIG. 20;
FIG. 22 is another schematic diagram illustrating a portion of a disassembled structure of the core assembly shown in FIG. 18;
FIG. 23 is a schematic diagram illustrating a sectional structure of the core assembly shown in FIG. 2;
FIG. 24 is a schematic diagram illustrating a portion of a sectional structure of the core assembly shown in FIG. 23;
FIG. 25 is a schematic diagram illustrating a portion of a structure of a core assembly shown in FIG. 17;
FIG. 26 is a schematic diagram illustrating a cross-section of a core assembly shown in FIG. 25 along M1-M2;
FIG. 27 is a schematic diagram illustrating a cross-section of a core assembly shown in FIG. 26 along M3-M4;
FIG. 28 is a schematic diagram illustrating a non-limiting partial exploded structure of a core assembly shown in FIG. 17;
FIG. 29 is a schematic diagram illustrating a structure of a support base in FIG. 28 assembled with a shell assembly and applied with adhesives;
FIG. 30 is a schematic diagram illustrating a top view of a structure shown in FIG. 28;
FIG. 31 is another schematic diagram illustrating a non-limiting partial exploded structure of a core assembly shown in FIG. 17;
FIG. 32 is an enlarged structural schematic diagram of a region M5 in FIG. 31;
FIG. 33 is a schematic diagram illustrating a structure of a support base of a microphone assembly in FIG. 17, matched with a shell assembly shown in FIG. 31;
FIG. 34 is a schematic diagram illustrating a structure of a support base in FIG. 33 from another perspective;
FIG. 35 is a schematic diagram illustrating a top view of a support base shown in FIG. 33 assembled with a support base in FIG. 31;
FIG. 36 is a schematic diagram illustrating a simplified structure of a support base in FIG. 33 and a shell assembly in FIG. 32 sealed with a fourth sealant;
FIG. 37 is a schematic diagram illustrating a simplified structure of a support base in FIG. 33 and a shell assembly from FIG. 32 sealed with a fifth sealant;
FIG. 38 is a schematic diagram illustrating another structure of a support base of a microphone assembly shown in FIG. 17;
FIG. 39 is a schematic diagram illustrating a structure of a support base in FIG. 38 assembled with a shell assembly; and
FIG. 40 is a schematic diagram illustrating a portion of a cross-section of a tuning assembly and a support base in a core assembly.

### DETAILED DESCRIPTION

The present application is described in further detail below in conjunction with the accompanying drawings and embodiments. In particular, it is noted that the following embodiments are only used to illustrate the present disclosure, but do not limit the scope of the present disclosure. Similarly, the following embodiments are only part of the embodiments of the present disclosure rather than all of the embodiments, and all other embodiments obtained by a person of ordinary skill in the art without creative labor fall within the scope of protection of the present disclosure.

References to "embodiments" in the present disclosure mean that particular features, structures, or characteristics described in conjunction with embodiments may be included in at least one embodiment of the present disclosure. It is understood by those of skill in the art, both explicitly and implicitly, that the embodiments described in the present disclosure may be combined with other embodiments.

The following embodiments of the present disclosure describe an exemplary structure of an earphone 100.

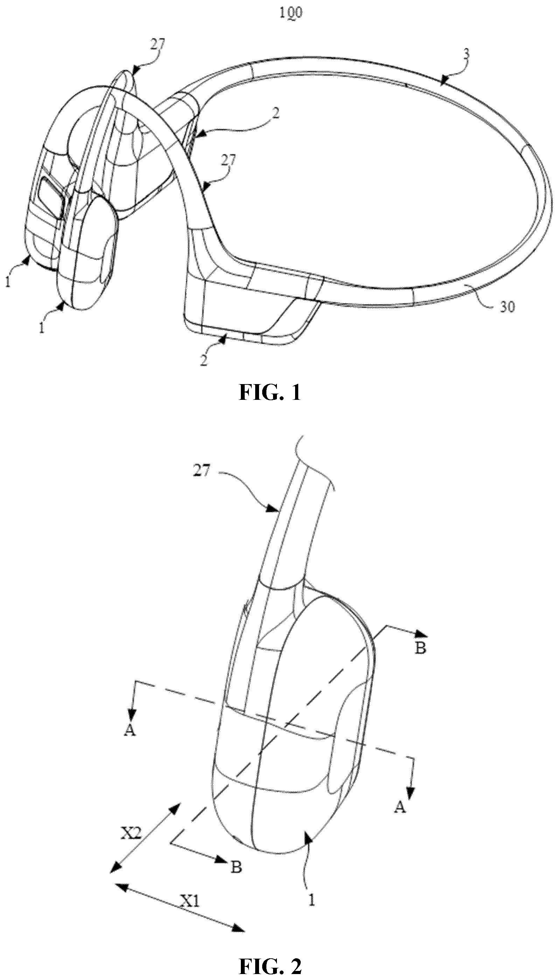

As shown in FIG. 1, the earphone 100 may include a core assembly 1, an ear-hook assembly 2, and a rear-hook assembly 3. There may be two core assemblies 1. The two core assemblies 1 are used to transmit vibration and/or sound to the user's left ear and right ear, respectively. The two core assemblies 1 may be the same or different. For example, one of the core assemblies 1 may be provided with a microphone, and another core assembly 1 may not be provided with a microphone. For example, one of the core assemblies 1 may be provided with a key and a corresponding circuit board, and another core assembly 1 may not be provided with a key and a corresponding circuit board. The two core assemblies 1 may be identical on a core module (e.g. a loudspeaker module). The core assembly 1 described in the following text can be considered as being detailed with one of the two core assemblies 1 as an example. There may be two ear-hook assemblies 2, and the two ear-hook assemblies 2 may be located on the user's left and right ears, respectively, so that the core assemblies 1 can be fitted to the user's face. For example, one of the ear-hook assemblies 2 may be provided with a battery, and another ear-hook assembly 2 may be provided with a control circuit, or the like. One end of the ear-hook assembly 2 is connected to the core assembly 1, and another end of the ear-hook assembly 2 is connected to the rear-hook assembly 3. The rear-hook assembly 3 connects the two ear-hook assemblies 2, and the rear-hook assembly 3 is used to wrap around the back of a user's neck or the back of a user's head and provide a clamping force that allows the two core assemblies 1 to be clamped to two sides of a user's face and the ear-hook assemblies 2 to be more securely attached to the user's ears. It should be understood that the earphone 100 may also not include the rear-hook assembly 3, and the core assembly 1 may be worn on the user's ears through the ear-hook assembly 2.

The following content primarily provides an exemplary description of the core assembly 1 and other structures of the earphone 100.

As shown in FIG. 2, FIG. 3, FIG. 4, and FIG. 5, the core assembly 1 may include a shell assembly 10, a bone-conducting loudspeaker 11, and an air-conducting loudspeaker 12.

Optionally, the shell assembly 10 may be provided with an accommodation cavity 1001 and an accommodation cavity 1002 that are isolated from each other. The shell assembly 10 may also be referred to as a core shell assembly 10. The bone-conducting loudspeaker 11 is accommodated in the accommodation cavity 1001, and the accommodation cavity 1001 may be referred to as a first accommodation cavity. The air-conducting loudspeaker 12 is accommodated in the accommodation cavity 1002, and the accommodation cavity 1002 may be referred to as a second accommodation cavity.

The air-conducting loudspeaker 12 conducts the sound into the ear canal of the user through air vibration, and the bone-conducting loudspeaker 11 conducts the sound into the user through bone-conducting vibration. Optionally, the sealing performance of the accommodation cavity 1001 is greater than the sealing performance of the accommodation cavity 1002. The sealing performance can be considered as airtightness. Optionally, the accommodation cavity 1001 may be provided as a completely airtight accommodation cavity, and the accommodation cavity 1002 is provided as an accommodation cavity with a relatively high degree of sealing performance while guaranteeing sound generation of the air-conducting loudspeaker 12. In the above-described manner, as the accommodation cavity 1002 in which the air-conducting loudspeaker 12 is placed needs to be connected to the outside world to facilitate the conduction of the sound waves through the air, the bone-conducting loudspeaker 11 and the air-conducting loudspeaker 12 are separately and independently arranged. There is no need to set the bone-conducting loudspeaker 11 in the accommodation cavity 1002. Instead, the bone-conducting loudspeaker 11 is separately arranged in the accommodation cavity 1001, and since the accommodation cavity 1001 is independent, it is possible to set the sealing performance of the accommodation cavity 1001 at a higher level, which effectively enhances the sealing effect of the bone-conducting loudspeaker 11, thereby preventing the bone-conducting loudspeaker 11 from being damaged by erosion of the external environmental factors, and at the same time guaranteeing the sound quality effect of the air-conducting loudspeaker 12. Additionally, in the earphone 100, when the bone-conducting loudspeaker 11 and the air-conducting loudspeaker 12 are operating at the same time, the bone-conducting loudspeaker 11 and the air-conducting loudspeaker 12 are arranged in the accommodation cavity 1001 and the accommodation cavity 1002, respectively, which can effectively reduce mutual interference between the bone-conducting loudspeaker 11 and the air-conducting loudspeaker 12, thereby effectively enhancing the sound quality of the earphone 100.

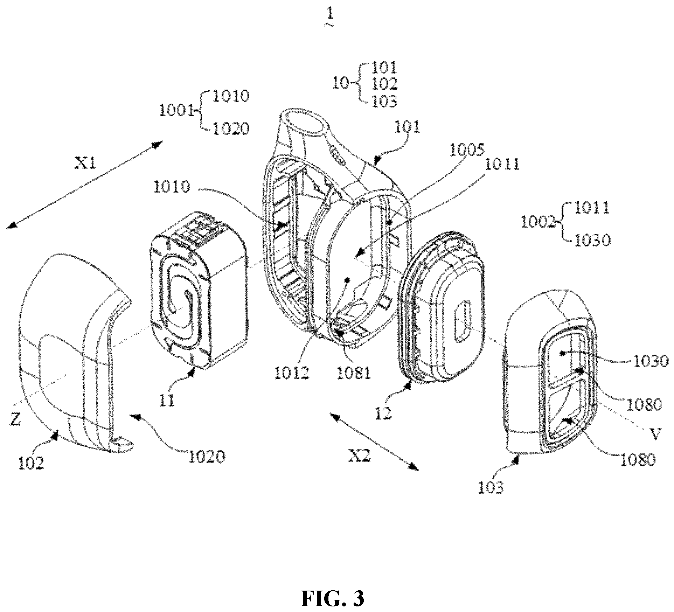

Optionally, referring to FIG. 2 and FIG. 3, the shell assembly 10 may include a shell 101, a shell 102, and a shell 103, and the shell 101 and the shell 102 fit with each other to form the accommodation cavity 1001. The shell 101 and/or the shell 102 further form a portion of the accommodation cavity 1002, and the shell 103 may form another portion of the accommodation cavity 1002, and in turn, the shell 103 and the shell 101 and/or the shell 102 fit with each other to form the accommodation cavity 1002.

The shell assembly 10 may be composed of the shell 101, the shell 102, and the shell 103. The shell 101 and the shell 102 fit with each other to form the accommodation cavity 1001, and the shell 103 and the shell 101 fit with each other to form the accommodation cavity 1002. The shell assembly 10 is formed by the shell 101, the shell 102 and the shell 103 fitting with each other in the structure described above, which can make the core assembly 1 compact and at the same time facilitate the assembly of the core assembly 1, thereby enhancing the assembly efficiency of the core assembly 1. In some embodiments, the shell 101 may be referred to as a first shell; the shell 102 may be referred to as a second shell; and the third shell 103 may be referred to as a third shell.

As another example, a portion of the accommodation cavity 1002 may also be provided in the shell 102. The shell 103 and the shell 102 form the accommodation cavity 1002 by fitting with each other, or the shell 101 and the shell 102 fit with each other to form a portion of the accommodation cavity 1002, and the shell 103, the shell 101, and the shell 102 fit with each other to form the accommodation cavity 1002.

Through the above structure, it is possible to place the bone-conducting loudspeaker 11 and the air-conducting loudspeaker 12 in the accommodation cavity 1001 and the accommodation cavity 1002 which are independent of each other, respectively, reducing the mutual influence between the bone-conducting loudspeaker 11 and the air-conducting loudspeaker 12. This setup maximizes the acoustic output of both the air-conducting loudspeaker 12 and the bone-conducting loudspeaker 11, while enabling a compact structure of the core assembly 1, which in turn contributes to the miniaturization of the core assembly 1 and facilitates its assembly, thereby improving the assembly efficiency of the core assembly 1.

Optionally, a vibration direction of the bone-conducting loudspeaker 11 is arranged to intersect with a vibration direction of the air-conducting loudspeaker 12, and the shell 101 and the shell 102 fit along the vibration direction of the bone-conducting loudspeaker 11. The shell 103 fits with the shell 101 and/or the shell 102 along the vibration direction of the air-conducting loudspeaker 12.

Specifically, the vibration direction of the bone-conducting loudspeaker 11 is arranged to intersect with the vibration direction of the air-conducting loudspeaker 12. The vibration direction of the bone-conducting loudspeaker 11 is referred to as a bone-conducting vibration direction X1, and the vibration direction of the air-conducting loudspeaker 12 is referred to herein as an air-conducting vibration direction X2, wherein the bone-conducting vibration direction X1 and the air-conducting vibration direction X2 are arranged to intersect rather than being parallel to each other. For example, the bone-conducting vibration direction X1 and the air-conducting vibration direction X2 are arranged perpendicularly or approximately perpendicular to each other (e.g., 90° ± 10°). When the bone-conducting loudspeaker 11 and the air-conducting loudspeaker 12 are operating at the same time, the bone-conducting loudspeaker 11 and the air-conducting loudspeaker 12 are vibrating along the bone-conducting vibration direction X1 and the air-conducting vibration direction X2, respectively. Since the two vibration directions are arranged to intersect with each other, this can effectively mitigate the impact of the bone-conducting loudspeaker 11's vibration on the sound quality of the air-conducting loudspeaker 12. Further, the shell 101 and the shell 102 may be assembled in conjunction with each other along the bone-conducting vibration direction X1, and the shell 103 and the shell 101 may be assembled in conjunction with each other along the air-conducting vibration direction X2. For example, the accommodation cavity 1002 may be formed by only the shell 101 and the shell 103 fitting together, with the shell 103 having a fitting relationship only with the shell 101 along the air-conducting vibration direction X2. As another example, instead of fitting with the shell 101 to form the accommodation cavity 1002, the shell 103 may fit with other shells along the air-conducting vibration direction X2 to form the accommodation cavity 1002, or the shell 103 may fit with the shell 101 and other shells to form the accommodation cavity 1002. In this way, it is favorable for the assembly of the core assembly 1 to enhance the efficiency of the assembly of the core assembly 1.

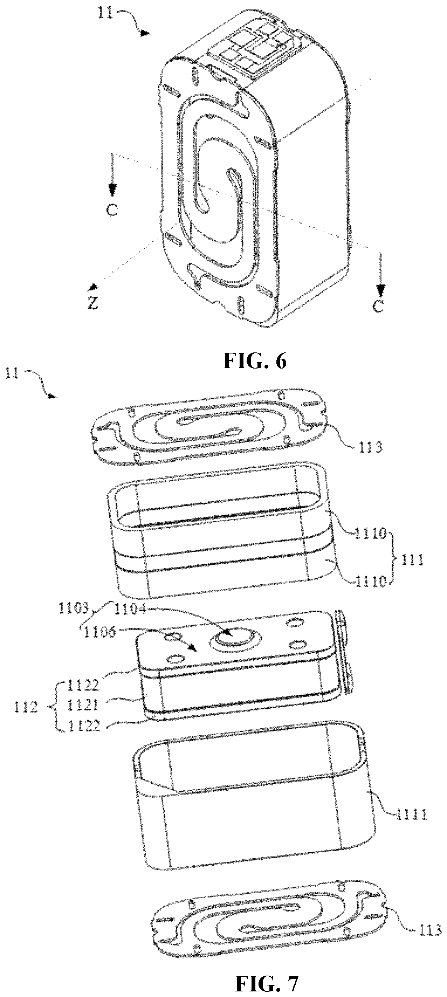

Referring to FIG. 6 and FIG. 7, optionally, the bone-conducting loudspeaker 11 includes a voice coil assembly 111 and a magnet assembly 112. The voice coil assembly 111 is provided around the magnet assembly 112 and is fixedly connected to the shell 101 and/or the shell 102. The surface of the shell 101 and/or the shell 102 that is disposed opposite to the bone-conducting loudspeaker 11 along the vibration direction of the bone-conducting loudspeaker 11 is configured to contact the user's skin and transmit bone-conducting vibration.

Optionally, referring to FIG. 6, FIG. 7, and FIG. 8, the voice coil assembly 111 includes two sets of voice coils 1110 spaced apart along a central axis direction Z of the bone-conducting loudspeaker 11 and a magnetic conduction shield 1111 surrounding an outer periphery of the two sets of voice coils 1110. The magnet assembly 112 includes a magnet 1121 and two magnetic conduction plates 1122, and the two magnetic conduction plates 1122 are respectively disposed on opposite end surfaces of the magnet 1121 along the central axis direction Z. Projections of the two magnetic conduction plates 1122 along a radial direction of the bone-conducting loudspeaker 11 overlap with the two sets of voice coils 1110, respectively, and current directions of the two sets of voice coils 1110 are opposite to each other. The central axis direction Z of the bone-conducting loudspeaker 11 coincides with the vibration direction of the bone-conducting loudspeaker 11 (i.e., the bone-conducting vibration direction X1).

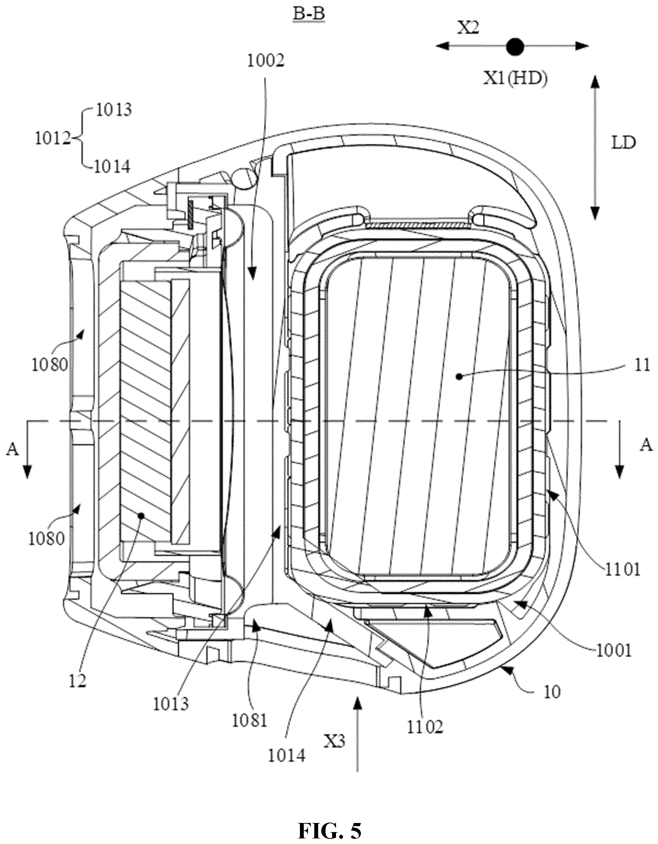

Optionally, referring to FIG. 5, FIG. 7 and FIG. 8, an outer peripheral surface of the magnetic conduction shield 1111 may be in contact with the shell assembly 10 and/or fixedly connected to the shell assembly 10 by an adhesive material, whereby the bone-conducting loudspeaker 11 and the shell assembly 10 can be rigidly connected/rigidly contacted, such that the bone-conducting loudspeaker 11 can be securely accommodated within the accommodation cavity 1001. Further, the outer peripheral surface of the magnetic conduction shield 1111 may be completely in contact with the shell assembly 10 or a portion of the outer peripheral surface may be in contact with the shell assembly 10. Further, a portion of the outer peripheral surface of the magnetic conduction shield 1111 may be partially connected to the shell assembly 10 and another portion may be fixedly connected to the shell assembly 10 by an adhesive material. For the portion in contact with the shell assembly 10, the shell assembly 10 and/or the outer peripheral surface of the magnetic conduction shield 1111 may be provided with a structure such as a supporting convex rib, supporting bump, or the like, to realize the partial contact between the two.

For example, the outer peripheral surface of the magnetic conduction shield 1111 is in contact with the shell assembly 10 and/or is fixedly connected to the shell assembly 10 by an adhesive material along at least two normal directions perpendicular to each other (a normal direction of the outer peripheral surface of the magnetic conduction shield 1111). Optionally, the outer peripheral surface of the magnetic conduction shield 1111 is in contact with the shell assembly 10 along a first direction and/or is fixedly connected to the shell assembly 10 by an adhesive material. For example, the outer peripheral surface of the magnetic conduction shield 1111 is in contact with the shell assembly 10 along a second direction and/or is fixedly connected to the shell assembly 10 by an adhesive material. For example, the first direction includes a first positive direction and a first negative direction that are opposite to each other. For example, the outer peripheral surface of the magnetic conduction shield 1111 is in contact with the shell assembly 10 and/or is fixedly connected to the shell assembly 10 by an adhesive material along the first positive direction and/or along the first negative direction. The second direction includes a second positive direction and a second negative direction that are opposite to each other. For example, the outer peripheral surface of the magnetic conduction shield 1111 is in contact with the shell assembly 10 and/or is fixedly connected to the shell assembly 10 by an adhesive material along the second positive direction and/or the second negative direction. The first direction is perpendicular to the second direction. The perpendicular mentioned here may allow for some deviation, such as angles ranging from 80° to 100°, all of which can be considered perpendicular.

As shown in FIG. 7, the outer peripheral surface of the magnetic conduction shield 1111 may include, for example, two opposite first outer side surfaces and two opposite second outer side surfaces. Each of the second outer side surfaces is located between the two first outer side surfaces, and the two second outer side surfaces and the two first outer side surfaces enclose an annular structure. For example, each of the first outer side surfaces is in contact with and/or fixedly connected to the shell assembly 10 by an adhesive material, and each of the second outer side surfaces is in contact with and/or fixedly connected to the shell assembly 10 by an adhesive material. For example, the two first outer side surfaces may be arranged opposite along the first direction, and the two second outer side surfaces may be arranged opposite along the second direction. For example, the first direction may be a direction X2 illustrated in FIG. 5 and the second direction may be a direction LD illustrated in FIG. 5.

Optionally, each of the second outer side surfaces and the two first outer side surfaces may be connected directly at an angle (corner) to each other, e.g. vertically. The transition between each second outer side surface and the two first outer side surfaces may also be curved, such as being connected by a curved connection surface. In this way, there is at least one curved connection surface between the two second outer side surfaces and the two first outer side surfaces. For example, there are four curved connection surfaces. Further, at least one curved connection surface is in contact with the shell assembly 10 or is fixedly connected to the shell assembly 10 by an adhesive material, or four curved connection surfaces are in contact with the shell assembly 10 or are fixedly connected to the shell assembly 10 by an adhesive material.

Set up in this way, a rigid contact/rigid connection can be realized between the bone-conducting loudspeaker 11 and the shell assembly 10, effectively improving the overall strength of the shell assembly 10 and making the vibration transmission between the two more efficient, thereby reducing noises and sound leakage.

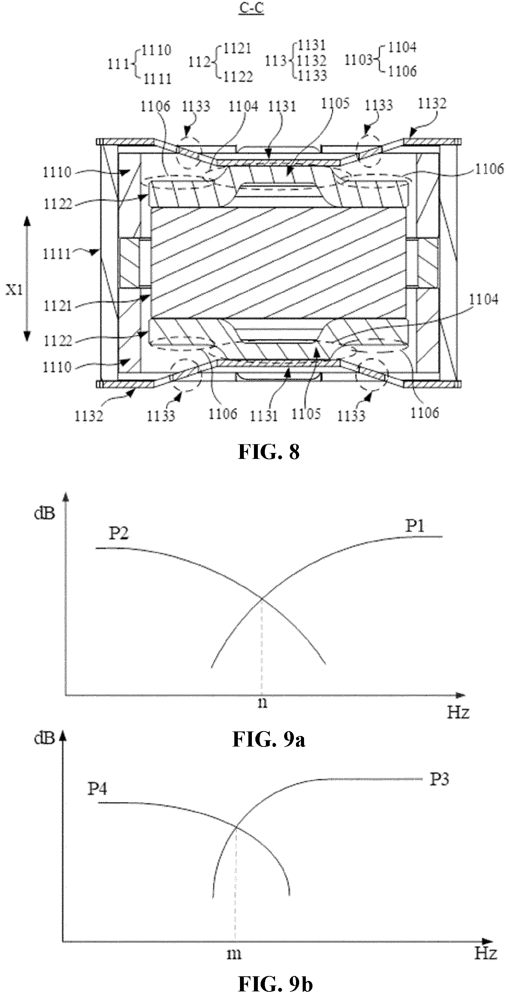

Referring to FIG. 9a, optionally, the earphone 100 includes a first operation mode and a second operation mode. In the first operation mode, the bone-conducting loudspeaker 11 plays sound signals in a first frequency band P1, and the air-conducting loudspeaker 12 plays sound signals in a second frequency band P2. In the second operation mode, the bone-conducting loudspeaker 11 plays sound signals in the first frequency band P1 and sound signals in the second frequency band P2, and the first frequency band P1 and the second frequency band P2 are at least partially offset in a frequency domain. For example, if the first frequency band P1 and the second frequency band P2 do not overlap in the frequency domain, a frequency range of the first frequency band P1 is higher than a frequency range of the second frequency band P2. For example, if the first frequency band P1 and the second frequency band P2 partially overlap in the frequency domain, a frequency range of an offset portion of the first frequency band P1 is higher than a frequency range of an offset portion of the second frequency band P2.

In some embodiments, the earphone 100 includes a frequency division point n (as shown in FIG. 9a), the first frequency band P1 includes a frequency band that is greater than the frequency division point n, and the second frequency band P2 includes a frequency band that is lower than the frequency division point n. The frequency division point n is located at an intersection point of the first frequency band P1 and the second frequency band P2. When the earphone 100 is in the first operation mode, the bone-conducting loudspeaker 11 and the air-conducting loudspeaker 12 are operating together, the bone-conducting loudspeaker 11 mainly outputs sound signals in the first frequency band P1, and the air-conducting loudspeaker 12 mainly outputs sound signals in the second frequency band P2. That is, an operation frequency band of the bone-conducting loudspeaker 11 includes a frequency band greater than the frequency division point n, and an operation frequency band of the air-conducting loudspeaker 12 includes a frequency band lower than the frequency division point n.

Referring to FIG. 9b, FIG. 9b illustrates an electrical signal band P3 input into the bone-conducting loudspeaker 11 and an electrical signal band P4 input into the air-conducting loudspeaker 12, respectively, when the earphone 100 is in the first operation mode. In some embodiments, the electrical signal band P3 of the bone-conducting loudspeaker 11 and the electrical signal band P2 of the air-conducting loudspeaker 12 have an overlapping intersection point m. The frequency division point n is located within a frequency range of 0.5 to 3 times the frequency span of the overlapping intersection point m. For example, if the overlapping intersection point m is 300 Hz, the frequency division point n may be located in a range of 150 Hz to 900 Hz, such as 500 Hz.

In some embodiments, the first frequency band P1 includes a mid-high frequency or a high frequency, and the second frequency band P2 includes a mid-low frequency or a low frequency. For example, a low-frequency range of 30Hz to 150Hz is considered a low-frequency band, a mid-frequency range of 150Hz to 500Hz is a mid-low frequency band, and 500Hz to 5KHz is a mid-high frequency band, and a high-frequency range of 5KHz to 16KHz is a high-frequency band.

When the earphone 100 is in the first operation mode, the bone-conducting loudspeaker 11 and the air-conducting loudspeaker 12 are operating together, the bone-conducting loudspeaker 11 mainly outputs sound signals in the first frequency band P1, and the air-conducting loudspeaker 12 mainly outputs sound signals in the second frequency band P2. In the earphone 100, the bone-conducting loudspeaker 11 and the air-conducting loudspeaker 12 operate together, wherein the bone-conducting loudspeaker 11 outputs the sound signals in the first frequency band P1 and the air-conducting loudspeaker 12 outputs the sound signals in the second frequency band P2. These signals are combined to form a more complete sound signal that is transmitted to the user's ear, which enhances the sound quality of the mid-low frequency band of the sound signal emitted by the earphone 100, thereby significantly improving the overall sound quality of the sound signal emitted by the earphone 100. Furthermore, the bone-conducting loudspeaker 11 may also operate separately, i.e., in the second operation mode, the air-conducting loudspeaker 12 does not work, and the bone-conducting loudspeaker 11 may simultaneously output sound signals in the first frequency band P1 and sound signals in the second frequency band P2. For example, when the earphone 100 is working in an environment where the user is sweating heavily during exercise or where the user is in a humid and rainy environment, the earphone 100 may actively cut off the operation of the air-conducting loudspeaker 12, and only the bone-conducting loudspeaker 11 is used for sound generation, thereby ensuring the overall sound quality of the sound signal emitted by the earphone 100 while preventing the air-conducting loudspeaker 12 from being eroded by unfavorable factors such as sweat or rain, effectively enhancing the reliability and stability of the earphone 100.

Optionally, the earphone 100 may further include a third operation mode. In the third operation mode, the air-conducting loudspeaker 12 plays sound signals in the first frequency band P1 and the second frequency band P2. Specifically, the earphone 100 switches to the third operation mode in response to detecting that the bone-conducting loudspeaker 11 is damaged and unavailable or that the environment in which the earphone 100 is currently located is unfavorable for the bone-conducting loudspeaker 11 to operate. In the third operation mode, the air-conducting loudspeaker 12 operates alone and outputs sound signals in the first frequency band P1 and the second frequency band P2, to ensure that the earphone 100 can output high-quality sound signals normally.

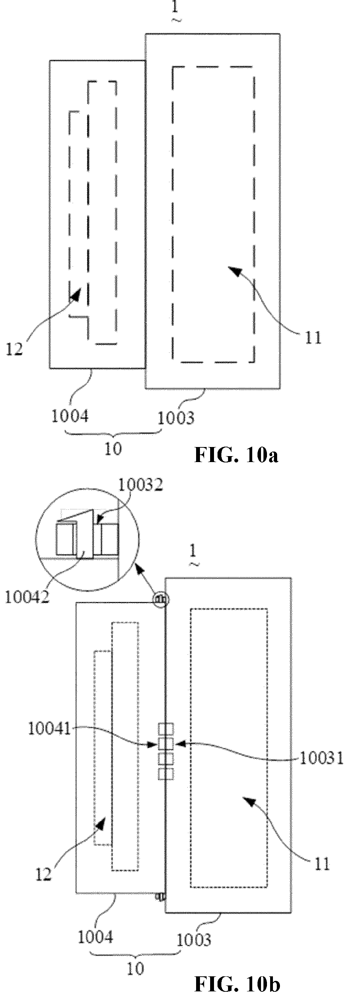

An alternative embodiment of the shell assembly 10 as illustrated in FIG. 10a and FIG. 10b is described below, and different from the shell assembly 10 described above, the shell assembly 10 hereinafter includes a first portion 1003 and a second portion 1004, with the first portion 1003 being connected to a wearing assembly 27 (as illustrated in FIG. 1 and FIG. 2). The second portion 1004 is detachably connected to the first portion 1003 or the wearing assembly 27. The bone-conducting loudspeaker 11 is provided on the first portion 1003, and the air-conducting loudspeaker 12 is provided on the second portion 1004 and can be removed from the wearing assembly 27 in a detachable manner. In other words, the shell assembly 10 includes the detachable first portion 1003 and the detachable second portion 1004. The bone-conducting loudspeaker 11 is provided on the first portion 1003, the air-conducting loudspeaker 12 is provided on the second portion 1004, and the second portion 1004 is detachably connected to the first portion 1003 or the wearing assembly 27. With this arrangement, the air-conducting loudspeaker 12 can be separately detachable from the rest of the components on the earphone 100, and the bone-conducting loudspeaker 11 can continue to operate after the air-conducting loudspeaker 12 is separately detached. Separately detaching the air-conducting loudspeaker 12 from the other components of the earphone 100 can enhance the environmental adaptability of the earphone 100, which allows the air-conducting loudspeaker 12 to be quickly detached from the earphone 100 in extreme environments, such as when the user is sweating heavily during exercise or in humid and rainy conditions, preventing damage to the air-conducting loudspeaker 12. Meanwhile, the earphone 100 can continue to output high-quality sound signals through the bone-conducting loudspeaker 11. When only the bone-conducting loudspeaker 11 in the earphone 100 is operating alone, the earphone 100 can control the bone-conducting loudspeaker 11 to operate through the second operation mode, to ensure the sound quality of the sound signals output by the earphone 100. Furthermore, the second portion 1004 is detachably connected to the first portion 1003 or the wearing assembly 27, which facilitates the replacement of the second portion 1004. On one hand, this allows for the replacement with the air-conducting loudspeaker 12 of different performance characteristics, and on the other hand, it also makes maintenance easier.

Optionally, as shown in FIG. 10b, the earphone 100 has a wire group for supplying power and/or audio signals to, for example, the bone-conducting loudspeaker 11 and the air-conducting loudspeaker 12. The wire group may be connected within the first portion 1003. The first portion 1003 may be provided with a first electrode portion 10031, and the second portion 1004 may be provided with a second electrode portion 10041. After the first portion 1003 and the second portion 1004 are detachably assembled, the first electrode portion 10031 and the second electrode portion 10041 are in contact and can be electrically connected. The first electrode portion 10031 and the second electrode portion 10041 may have various structures, for example, the first electrode portion 10031 includes at least two first electrode contacts. The second electrode portion 10041 includes at least two second electrode contacts, and the at least two first electrode contacts and the at least two second electrode contacts may be in one-to-one correspondence. For example, one of the first electrode portion 10031 and the second electrode portion 10041 includes a pogo pin, and another includes a leaf spring or contact. The electrical connection is established through the contact between the pogo pin and the leaf spring or contact. For example, the first electrode portion 10031 and the second electrode portion 10041 each includes a leaf spring, and the electrical connection is realized by the elastic contact between the leaf springs of the first electrode portion 10031 and the second electrode portion 10041. As another example, the first electrode portion 10031 and the second electrode portion 10041 include other forms. For example, the first electrode portion 10031 includes a plurality of ring electrodes that are nested together, and the second electrode portion 10041 includes a plurality of ring electrodes that are nested together. The first electrode portion 10031 and the second electrode portion 10041 may establish an electrical connection through the corresponding contact between their ring electrodes. The first electrode portion 10031 and the second electrode portion 10041 are not limited to the examples listed above, and the first electrode portion 10031 and the second electrode portion 10041 are configured to ensure electrical connection when the first portion 1003 and the second portion 1004 are assembled and to allow for their separation after disassembly.

In some implementations, the wire group is coupled to the bone-conducting loudspeaker 11 and the first electrode portion 10031, and the second electrode portion 10041 is coupled to the air-conducting loudspeaker 12. After the second portion 1004 and the first portion 1003 are assembled, the first electrode portion 10031 and the second electrode portion 10041 are in contact with each other correspondingly and are conductive such that the wire group is also capable of powering and/or providing audio signals to the air-conducting loudspeaker 12.

In other embodiments, the first electrode portion 10031 is coupled to the bone-conducting loudspeaker 11, and the second electrode portion 10041 is coupled to the air-conducting loudspeaker 12. The wire group is coupled to at least two first electrode portions 10031, and the wire group may supply power and/or audio signals to the bone-conducting loudspeaker 11 through the first electrode portion 10031, and may also supply power and/or audio signals to the air-conducting loudspeaker 12 through the contact between the first electrode portion 10031 and the second electrode portion 10041.

As another example, the wire group may also be connected to the second portion 1004, the first portion 1003 is detachably connected to the second portion 1004, and a specific connection relationship can be referred to the above description.

The first portion 1003 is provided with a first connection portion 10032, and the second portion 1004 is provided with a second connection portion 10042. The first connection portion 10032 and the second connection portion 10042 are detachably connected by snap-fit, adhesion, magnetic suction, threaded connection, or the like. For example, the first connection portion 10032 may be provided as one of a slot or a snap, and the second connection portion 10042 may be provided as another of a slot or a snap. The first portion 1003 and the second portion 1004 are detachably connected by a snap-fit mechanism, allowing the first electrode portion 10031 and the second electrode portion 10041 to contact each other and establish an electrical connection.

Referring to FIG. 3 and FIG. 5, optionally, the shell assembly 10 may also be provided with a pressure relief hole 1081 for connecting the accommodation cavity 1002 to the external environment. The pressure relief hole 1081 is provided to extend toward the side where the accommodation cavity 1001 is located. Specifically, the bone-conducting loudspeaker 11 and the air-conducting loudspeaker 12 may be accommodated in the accommodation cavity 1001 and the accommodation cavity 1002, respectively, and the shell assembly 10 is provided with the pressure relief hole 1081 for relieving pressure for the air-conducting loudspeaker 12. The pressure relief hole 1081 enables the accommodation cavity 1002 to be in communication with the external environment, and the pressure relief hole 1081 extends from the connection position with the accommodation cavity 1002 toward the side where the accommodation cavity 1001 is located. For example, a portion of a hole wall of the pressure relief hole 1081 extends from the connection position with the accommodation cavity 1002 toward the side where the accommodation cavity 1001 is located. With this setup, it is possible to effectively reduce the shell space occupied by the pressure relief hole 1081 on a periphery of the accommodation cavity 1002, making efficient use of the space between the accommodation cavity 1001 and the accommodation cavity 1002. This improves the spatial utilization of the shell assembly 10, enabling a more compact and reasonable configuration while meeting the sound production requirements of the air-conducting loudspeaker 12. Besides, such an inclined extension can increase the dimension of the pressure relief hole 1081, which makes it possible to provide the air-conducting loudspeaker 12 with better sound quality.

Optionally, a projection of the pressure relief hole 1081 along a direction X3 (shown in FIG. 5) perpendicular to an arrangement direction of the accommodation cavity 1001 and the accommodation cavity 1002 at least partially overlaps with the accommodation cavity 1001. The direction X3 perpendicular to the arrangement direction of the accommodation cavity 1001 and the accommodation cavity 1002 may be understood as a direction perpendicular to the bone-conducting vibration direction X1 and perpendicular to the air-conducting vibration direction X2. The projection of the pressure relief hole 1081 along the direction X3 at least partially overlaps with the accommodation cavity 1001, which ensures that the dimension of the pressure relief hole 1081 satisfies the pressure relief requirements of the air-conducting loudspeaker 12. At the same time, this arrangement effectively reduces the space occupied by the pressure relief hole 1081 and the corresponding shell portion, thereby reducing the structural dimension of the shell assembly 10 in the region where the air-conducting loudspeaker 12 is located.

Further, the pressure relief hole 1081 is provided to extend inclined toward the side on which the accommodation cavity 1001 is located, and along the direction X3 perpendicular to the arrangement direction of the accommodation cavity 1001 and the accommodation cavity 1002, the dimension of the pressure relief hole 1081 gradually increases in the direction from the accommodation cavity 1002 to the external environment. **In** other words, while the pressure relief hole 1081 extends inclined toward the accommodation cavity 1001, the dimension of the pressure relief hole 1081 gradually increases in the direction from the accommodation cavity 1002 to the external environment, which makes the air discharge smoother, and can reduce the velocity of the air, thereby enhancing the sound quality of the sound emitted by the earphone 100.

Referring to FIG. 3, FIG. 4, and FIG. 5, the shell assembly 10 includes a partition wall 1012 for isolating the accommodation cavity 1001 from the accommodation cavity 1002. At least a portion of the partition wall 1012 extends toward the side on which the accommodation cavity 1001 is located, and forms a portion of the hole wall of the pressure relief hole 1081.

Specifically, in a cross-section perpendicular to a vibration direction (i.e., the bone-conducting vibration direction X1) of the bone-conducting loudspeaker 11, the bone-conducting loudspeaker 11 has a long-side edge 1101 and a short-side edge 1102, with the long-side edge 1101 being longer than the short-side edge 1102. The partition wall 1012 includes a wall segment 1013 and a wall segment 1014. The wall segment 1013 is disposed side-by-side with the long-side edge 1101, and the wall segment 1014 is connected to the wall segment 1013 and extends from a periphery of the connection between the long-side edge 1101 and the short-side edge 1102 toward the side on which the accommodation cavity 1001 is located. The wall segment 1014 is used to form a portion of the hole wall of the pressure relief hole 1081. In some embodiments, the wall segment 1013 may be referred to as a first wall segment and the wall segment 1014 may also be referred to as a second wall segment.

The above spatial layout and structural arrangement of the pressure relief hole 1081 may be realized by the shell assembly 10. It should be understood that the above spatial layout and structural arrangement of the pressure relief hole 1081 may also be realized by other solutions, which will not be discussed in detail herein. In addition to the earphone 100 provided with both the bone-conducting loudspeaker 11 and the air-conducting loudspeaker 12, the above spatial layout and structural arrangement of the pressure relief hole 1081 may also be applied to the earphone 100 provided with only the air-conducting loudspeaker 12, which will not be described in detail herein.

Optionally, as shown in FIG. 3, a central axis Z of the bone-conducting loudspeaker 11 (a central axis direction of the bone-conducting loudspeaker 11 may also be denoted by Z) may intersect with a central axis V of the air-conducting loudspeaker 12, or may not intersect with the central axis V of the air-conducting loudspeaker 12. For example, the central axis Z and the central axis V are skew lines, not lying in the same plane, and are arranged in a staggered manner. In a direction perpendicular to the central axis Z and the central axis V, the central axis Z is disposed farther away from the pressure relief hole 1081 compared to the central axis V. Generally speaking, along an LD direction shown in FIG. 5, the bone-conducting loudspeaker 11 is located farther away from the pressure relief hole 1081 compared to the air-conducting loudspeaker 12. By setting the central axis Z and the central axis V to be skew lines and by setting the central axis Z farther away from the pressure relief hole 1081 as compared to the central axis V, a larger space can be made available for the design of the pressure relief hole 1081, which in turn allows the dimension of the pressure relief hole 1081 to be larger, thereby enhancing the pressure relief effect.

Optionally, the distance between the central axis Z and the central axis V is in a range of 0.3 mm to 1 mm, in a range of 0.5mm to 0.8 mm, such as 0.6 mm, 0.7 mm, or in a range of 0.2 mm to 1.2 mm. By setting the above dimensions, on the one hand, it is possible to ensure the sound quality effect of the bone-conducting loudspeaker 11 and the air-conducting loudspeaker 12 while keeping the core assembly 1 small, and on the other hand, it is possible to provide a larger space for setting the pressure relief hole 1081, which in turn allows for the setting of a larger pressure relief hole 1081.

As mentioned above, the shell assembly 10 includes the shell 101, the shell 102, and the shell 103. The partition wall 1012 may be disposed on the shell 101 and/or the shell 102, and the shell 101 and the shell 102 fit with each other to form the accommodation cavity 1001 and the pressure relief hole 1081. For example, the shell 101 and/or the shell 102 further form a portion of the accommodation cavity 1002. For example, the shell 103 may form another portion of the accommodation cavity 1002, with the shell 103 fitting with the shell 101 and/or the shell 102 to form the accommodation cavity 1002. The partition wall 1012 disposed on the shell 101 and/or the shell 102 may be understood as the partition wall 1012 being a part of the shell 101 and/or the shell 102. It should be understood that how the partition wall 1012 is disposed is not limited to be disposed on the shell 101 and/or the shell 102. In other embodiments, the partition wall 1012 may be a component that is independent of the shell 101 and/or the shell 102.

As shown in FIG. 3, the partition wall 1012 is disposed on the shell 101, and the shell 101 is provided with a sub-accommodation cavity 1010 and a sub-accommodation cavity 1011 located on opposite sides of the partition wall 1012. An opening direction of the sub-accommodation cavity 1010 is oriented toward a wall surface of the partition wall 1012. Specifically, the opening direction of the sub-accommodation cavity 1010 is parallel or substantially parallel to the wall surface of the partition wall 1012. The opening direction of the sub-accommodation cavity 1011 intersects with the wall surface of the partition wall 1012. The shell 102 is provided with a sub-accommodation cavity 1020, the shell 102 is capped at an open end of the sub-accommodation cavity 1010, and the sub-accommodation cavity 1020 fits with the sub-accommodation cavity 1010 to form the accommodation cavity 1001. The shell 103 is provided with a sub-accommodation cavity 1030, the shell 103 is capped at an open end of the sub-accommodation cavity 1011, and the sub-accommodation cavity 1030 fits with the sub-accommodation cavity 1011 to form the accommodation cavity 1002. In some embodiments, the sub-accommodation cavity 1010 may also be referred to as a first sub-accommodation cavity, the sub-accommodation cavity 1011 may also be referred to as a second sub-accommodation cavity, the sub-accommodation cavity 1020 may also be referred to as a third sub-accommodation cavity, and the sub-accommodation cavity 1030 may also be referred to as a fourth sub-accommodation cavity.

By providing the partition wall 1012 to divide the shell 101 into the sub-accommodation cavity 1010 whose opening direction is oriented towards the wall surface of the partition wall 1012 and the sub-accommodation cavity 1012 that intersects with the wall surface of the partition wall 1012, both the sub-accommodation cavity 1010 and the sub-accommodation cavity 1012 can have larger spaces. This improves the spatial utilization of the shell 101 and helps reduce mutual interference caused by vibrations between the bone-conducting loudspeaker 11 and the air-conducting loudspeaker 12 during operation, thereby enhancing sound quality.

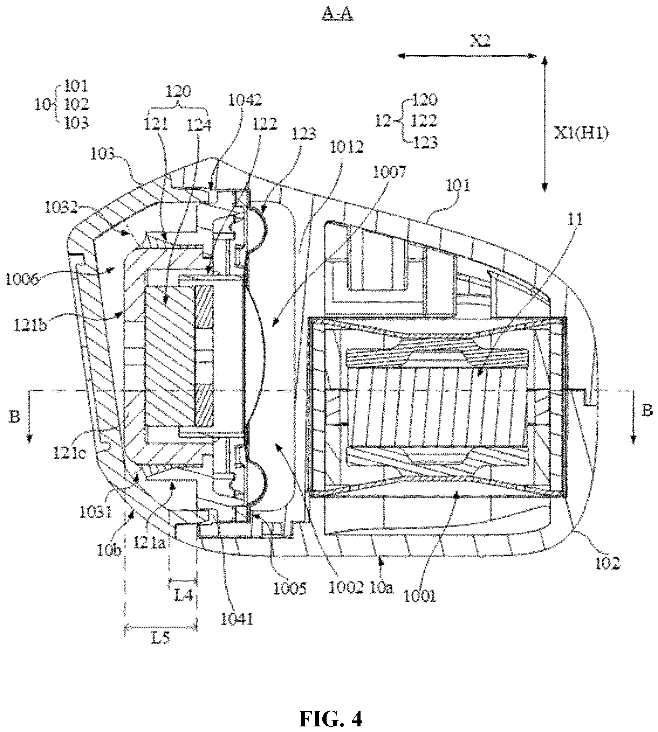

As shown in FIG. 4, the air-conducting loudspeaker 12 includes a vibration diaphragm 123. The vibration diaphragm 123 divides the accommodation cavity 1002 into a cavity portion 1006 disposed on the side of the vibration diaphragm 123 away from the partition wall 1012 and a cavity portion 1007 disposed between the vibration diaphragm 123 and the partition wall 1012. The pressure relief hole 1081 is in communication with the cavity portion 1007. As shown in FIG. 3 and FIG. 5, the shell assembly 10 is further provided with a sound outlet hole 1080 in communication with the cavity portion 1006. The cavity portion 1007 is in communication with the external environment via the pressure relief hole 1081. When the vibration diaphragm 123 vibrates along the air-conducting vibration direction X2, the cavity portion 1007 may be relieved of the pressure via the pressure relief hole 1081, to ensure normal and stable operation of the air-conducting loudspeaker 12. In some embodiments, the cavity portion 1006 may also be referred to as a first cavity portion, and the cavity portion 1007 may also be referred to as a second cavity portion.

Optionally, the distance between the vibration diaphragm 123 and a cavity wall of the accommodation cavity 1002 along a vibration direction of the vibration diaphragm 123 (the air-conducting vibration direction X2) is greater than 0.8 mm, or greater than 1 mm. Specifically, the distance (i.e., the distance along the air-conducting vibration direction X2) between the vibration diaphragm 123 and the partition wall 1012 (i.e., a portion of the cavity wall of the accommodation cavity 1002) may be greater than 0.8 mm, or greater than 1 mm. This ensures that the vibration diaphragm 123 has a larger vibration space, and the distance enables the airflow in the cavity portion 1007 to be distributed more uniformly, which in turn enables the air pressure to be more uniform and improves the consistency of the vibration of the vibration diaphragm 123. In some embodiments, the distance between the vibration diaphragm 123 and the partition wall 1012 refers to the minimum distance between the two. In other embodiments, the distance between the vibration diaphragm 123 and the partition wall 1012 refers to the distance between a vibration region of the vibration diaphragm 123 (e.g., a center region or a region of maximum amplitude) and the partition wall 1012.

As shown in FIG. 3 to FIG. 5, optionally, in a wearing state, the center of the pressure relief hole 1081 is not higher than the center of the sound outlet hole 1080, and in the wearing state, a line connecting the center of the pressure relief hole 1081 and the center of the sound outlet hole 1080 is pointed toward the user's ear. Optionally, in the wearing state, the line connecting the center of the pressure relief hole 1081 to the center of the sound outlet hole 1080 is pointed toward the ear canal of the user's ear. Generally speaking, the line connecting the center of the pressure relief hole 1081 and the center of the sound outlet hole 1080 may be inclined upward toward the head top direction relative to the human body and point toward the user's ear. The center of the pressure relief hole 1081 may be the centroid of the pressure relief hole 1081. The center of the sound outlet hole 1080 may be the centroid of the sound outlet hole 1080. This setup helps to avoid the user's ear (especially the ear canal) being at the acoustic null point in the wearing state or in cases of improper wearing (such as slight tilting). As a result, it ensures that the user can hear the sound properly, reducing hearing loss and improving sound quality.

If there is a plurality of sound outlet holes 1080, the line described above may be a line connecting the center of at least one of the sound outlet holes 1080 and the center of the pressure relief hole 1081. As another example, if there is a plurality of sound outlet holes 1080, a line connecting the centers of the plurality of sound outlet holes 1080 forms a shape, and the center of the shape serves as the center of the plurality of sound outlet holes 1080, and the line described above may be a line connecting the center of the shape and the center of the pressure relief hole 1081 that is pointed toward the user's ear.

Optionally, in the wearing state, an angle between the line connecting the center of the pressure relief hole 1081 and the center of the sound outlet hole 1080 and the coronal axis of the user is ≥0° and <90°, and an angle between the line and the vertical axis of the user is >0° and ≤90°. This setup helps to avoid the user's ear being at the acoustic null point in the wearing state or in cases of improper wearing (such as slight tilting). As a result, it ensures the output of the earphone 100 and the acoustic effect.

As shown in FIG. 4, the air-conducting loudspeaker 12 further includes a magnetic circuit assembly 120 and a voice coil 122. The magnetic circuit assembly 120 includes a cover body 121 with an open end 1211, and an annular flange 1212 that is disposed at the open end 1211 of the cover body 121 and protrudes from an outer peripheral surface of the cover body 121. A rim of the vibration diaphragm 123 is fixed to a side of the annular flange 1212 facing the open end 1211 and covers the open end 1211 of the cover body 121. The voice coil 122 is connected to the vibration diaphragm 123. As shown in FIG. 3 and FIG. 5, the vibration diaphragm 123 is arranged opposite to the cover body 121, away from the sound outlet hole 1080.

The air-conducting loudspeaker 12 requires a larger vibration diaphragm 123 to achieve good sound quality, and the larger vibration diaphragm 123 also requires a larger support structure such as the annular flange 1212. In other words, the annular flange 1212 and the vibration diaphragm 123 are both structures in the air-conducting loudspeaker 12 that have large radial dimensions compared to the other structures, which greatly affects the overall structural dimension of the shell assembly 10. By setting the annular flange 1212 and the vibration diaphragm 123 on the side away from the sound outlet hole 1080, the vibration diaphragm 123 and the annular flange 1212 can be located closer to the interior of the shell assembly 10. With such an arrangement, in the air-conducting loudspeaker 12, structures with a larger radial dimension are arranged away from the sound outlet hole 1080, and structures with a smaller dimension can be located closer to the sound outlet hole 1080. Such an opposite configuration inside the air-conducting loudspeaker 12, compared to the traditional loudspeaker design where the vibration diaphragm must be oriented toward the sound outlet hole 1080, effectively reduces the dimension of the portion of the shell assembly 10 that is near the sound outlet hole 1080, which allows the dimension of the shell assembly 10 to decrease from the central region to the region around the sound outlet hole 1080 (i.e., the radial dimension of the outer peripheral surface of the shell assembly 10 can gradually decrease). As a result, the structure becomes more compact, significantly improving the spatial utilization of the shell assembly 10 and reducing the overall volume of the shell assembly 10. Such an opposite configuration can optimize the sound path and thus improve the sound quality. **In** short, by reversing the air-conducting loudspeaker 12 along the air-conducting vibration direction X2, the structural dimension of the shell assembly 10 can be effectively reduced.

Optionally, as shown in FIG. 3 and FIG. 4, the cavity wall of the accommodation cavity 1002 is provided with an annular table surface 1005 (the annular table surface 1005 is also shown in FIG. 5, but not labeled). As shown in FIG. 4 and FIG. 5, the annular flange 1212 is pressed against the annular table surface 1005. The vibration diaphragm 123 divides the accommodation cavity 1002 into the cavity portion 1006 and the cavity portion 1007, with the cavity portion 1006 being disposed on the side of the vibration diaphragm 123 facing the sound outlet hole 1080 and the cavity portion 1007 being disposed on the side of the vibration diaphragm 123 away from the sound outlet hole 1080. The magnetic circuit assembly 120 is located within the cavity portion 1006. As shown in FIG. 5, the shell assembly 10 is provided with the pressure relief hole 1081 to enable communication between the cavity portion 1007 and the external environment. Specifically, the annular table surface 1005 may be provided on shell 101.

As shown in FIG. 4, the vibration diaphragm 123 may be disposed on the side of the annular flange 1212 toward the annular table surface 1005. The earphone 100 further includes a sealing adhesive 1041 that seals a gap between the side of the annular flange 1212 that is opposite the annular table surface 1005 and the shell assembly 10. The annular flange 1212 fits with the shell assembly 10 to form an adhesive accommodation groove 1042 for accommodating the sealing adhesive 1041 on the side of the annular flange 1212 that is opposite the annular table surface 1005. Based on reversing the air-conducting loudspeaker 12, since the vibration diaphragm 123 is closer to an inner side of the shell assembly 10 compared to the adhesive accommodation groove 1042, while the adhesive accommodation groove is closer to an outer side of the shell assembly 10, on the one hand, it is easy to dispense the adhesive, and on the other hand, when dispensing the adhesive on the adhesive accommodation groove 1042, it can prevent the adhesive from overflowing onto the vibration diaphragm 123, reducing the effect of the adhesive on the vibration diaphragm 123, thereby ensuring the sound quality effect.

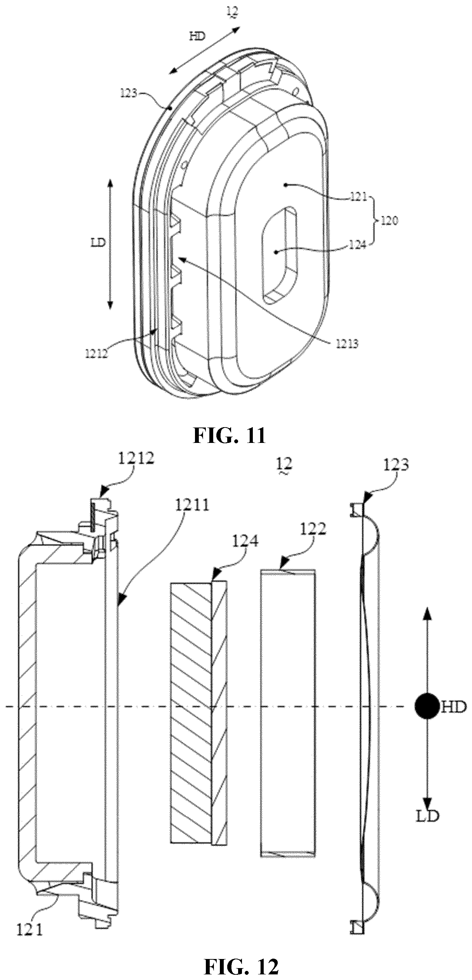

Further as shown in FIG. 11, a sound-conducting hole 1213 is disposed on the annular flange 1212. The sound-conducting hole 1213 is provided to connect a space surrounded by the vibration diaphragm 123 and the magnetic circuit assembly 120 to the cavity portion 1006 around the periphery of the magnetic circuit assembly 120. A portion of sound waves generated by the vibration of the vibration diaphragm 123 along the air-conducting vibration direction X2 is conducted via the sound-conducting hole 1213 to the cavity portion 1006 around the periphery of the magnetic circuit assembly 120.

Optionally, as shown in FIG. 4, the shell 103 is used to accommodate one end of the cover body 121 away from the vibration diaphragm 123, and the sound outlet hole 1080 is provided on the shell 103. The cover body 121 includes a circumferential side surface 121a and an end surface 121b, and the end surface 121b is connected to the circumferential side surface 121a. The end surface 121b is oriented toward the sound outlet hole 1080. A first gap 1031 (a position of the dashed line pointed to by the label 1031 in FIG. 4) exists between a connection region between the end surface 121b and the circumferential side surface 121a located on a first side of the cover body 121 and the shell 103. A second gap 1032 (a position of the dashed line pointed to by the label 1032 in FIG. 4) exists between a connection region between the circumferential side surface 121a located on a second side of the cover body 121 and the end surface 121b and the shell 103. The first gap 1031 is smaller than the second gap 1032. The size of the first gap 1031 and the size of the second gap 1032 may be distances between the corresponding connection regions to the shell 103, respectively. For example, the distance is the length of the dashed line illustrated in FIG. 4 (the dashed line may be perpendicular to an inner surface of the shell 103 at a corresponding location). The first side and the second side refer to a first side and a second side of the circumferential side surface 121a that are opposite to each other.

Referring to FIG. 4, FIG. 5, FIG. 11, and FIG. 12, in a cross-section perpendicular to the vibration direction of the vibration diaphragm 123, the cover body 121 has a length direction LD and a width direction HD. The dimension of the cover body 121 along the length direction LD is larger than the dimension of the cover body 121 along the width direction HD, and the first side and the second side are opposite along the width direction HD. The first side may be located on the side of the magnetic circuit assembly 120 close to the user's face, as shown in FIG. 4. The first gap 1031 is smaller than the second gap 1032, and the first gap 1031 is located on the first side, which in turn makes the smaller first gap 1031 closer to the user's face, and can ensure that the air-conducting loudspeaker 12 outputs sound signals normally, while also effectively reducing the dimension of the shell 103.

Further, the first side is located on the side of the magnetic circuit assembly 120 close to the user's face, and at least a portion of an outer surface of the shell 103 is provided inclined toward the shell 101 and the shell 102 along a direction from the second side to the first side. For example, the portion of the outer surface of the shell provided with the sound outlet hole 1080 is provided inclined toward the shell 101 and the shell 102 along a direction from the second side to the first side, i.e., the sound outlet hole 1080 is disposed on the at least a portion of the shell 103. With this setting manner, it is possible to make the sound outlet hole 1080 toward the user's ear, so that the sound signal output from the air-conducting loudspeaker 12 can be better transmitted into the user's ear. A portion of the shell 103 that is opposite the circumferential side surface 121a is connected to a portion of the shell provided with the sound outlet hole. Optionally, after reversing the air-conducting loudspeaker 12, an outer surface of the portion of the shell 103 that is opposite the circumferential side surface 121a may be provided in an inclined manner, and specifically, the outer surface may gradually converge and tilt along the air-conducting vibration direction X2, from the first shell 101 to the direction away from the first shell 101 and into the accommodation cavity 1002, to make the shell assembly 10 compact and miniaturized, thereby reducing the volume of the shell assembly 10. Moreover, the shell assembly 10 may have a fitting surface 10a in contact with the user's face and an inclined surface 10b (the inclined surface may be a curved inclined surface that gradually tilts away from the face) connected to the fitting surface 10a and tilted away from the fitting surface 10a. The inclined surface 10b is used to avoid the user's tragus, thereby reducing the compression on the tragus, facilitating wearing, improving the wearing comfort, and having better sound quality effect. The fitting surface 10a is mainly composed of the shell 102, and the inclined surface 10b may be composed of the shell 102 and the shell 103 together.

Further, a portion of the end surface 121b adjacent to the circumferential side surface 121a disposed on the first side may be connected to the shell 103, or a connection region between the end surface 121b and the circumferential side surface 121a disposed on the first side may be in contact with the shell 103, further reducing the dimension of the shell assembly 10. The contact here can be direct contact, where further adhesive bonding can be applied for fixation, or it can be indirect contact through adhesive fixation. A portion of the cavity portion 1006 that is on the periphery of the cover body 121 may be further divided into a first space portion and a second space portion by the above contact position. Specifically, the first space portion may be enclosed between the circumferential side surface 121a disposed on the first side and the shell 103, or the first space portion may be enclosed by a combination of the end surface 121b, the circumferential side surface 121a disposed on the first side, and the shell 103, while the second space portion may be enclosed between at least a portion of the end surface 121b, a portion of the circumferential side surface 121a disposed on the second side, and the shell 103. The first gap 1031 is located in the first space portion, the second gap is located in the second space portion, and the second space portion is in communication with the sound outlet hole 1080. If the end surface 121b encloses both the first space portion and the second space portion, the area of the portion of the end surface 121b enclosing the first space portion is smaller than the area of the portion of the end surface 121b enclosing the second space portion, i.e., the contact position is closer to the first side and to the portion of the shell assembly 10 opposite the first side. Corresponding positions of the cover body 121 and the shell 103 may be contacted to form the contact position. In other embodiments, the corresponding positions of the cover body 121 and the shell 103 may be set to have a gap whose distance is greater than 0.1 mm, and the gap is so set that the cover body 121 does not collide with the shell 103 when vibrates due to the vibration of the vibration diaphragm 123, thereby reducing the possibility of generating noise. In conclusion, corresponding to the contact position, a position corresponding to the gap is referred to as a minimum gap position.

In the state in which the contact position is set, at least a portion of sound waves can enter the second space portion from the first space portion along the circumferential side surface 121a, and then pass out from the second space portion via the sound outlet hole 1080.

Optionally, referring to FIG. 4, on the first side, the average distance between the annular flange 1212 and the shell 103 along the vibration direction X2 of the vibration diaphragm 123 is greater than or equal to 0.5 mm. Optionally, on the second side, the second gap 1032 is greater than or equal to 0.5 mm. On the first side, the average distance between the annular flange 1212 and the shell 103 along the vibration direction X2 of the vibration diaphragm 123 is the average value of the sum of the maximum distance L5 and the minimum distance L4 between the annular flange 1212 and the shell 103 along the vibration direction of the vibration diaphragm 123 (i.e., the air-conducting vibration direction X2).

By setting the above dimensions, on the one hand, it is ensured that there is a sufficient size of a sound cavity to achieve a better sound quality before leading the sound waves out of the sound outlet hole 1080, and on the other hand, it is possible to make the shell assembly 10 smaller and more compact. In addition, by reversing the accommodation cavity 1002 and the air-conducting loudspeaker 12 as shown in FIG. 4, the sound waves enter the second space portion from the first space portion along the circumferential side surface 121a (i.e., the sound waves can enter the second gap 1032 from the first gap 1031), and along the air-conducting vibration direction X2, the second space portion is gradually inclined to the first space portion to better point to the sound outlet hole 1080, so that the transmission direction of the sound waves is more directed to the user's ear, further enhancing the transmission efficiency of the sound waves, and enhancing the sound quality.

Optionally, as shown in FIG. 4, the cover body 121 includes a magnetic conduction shield 121c. The magnetic circuit assembly 120 further includes the magnet 124 disposed within the magnetic conduction shield 121c, and the voice coil 122 extends into a magnetic gap formed by the magnetic conduction shield 121c and the magnet 124.

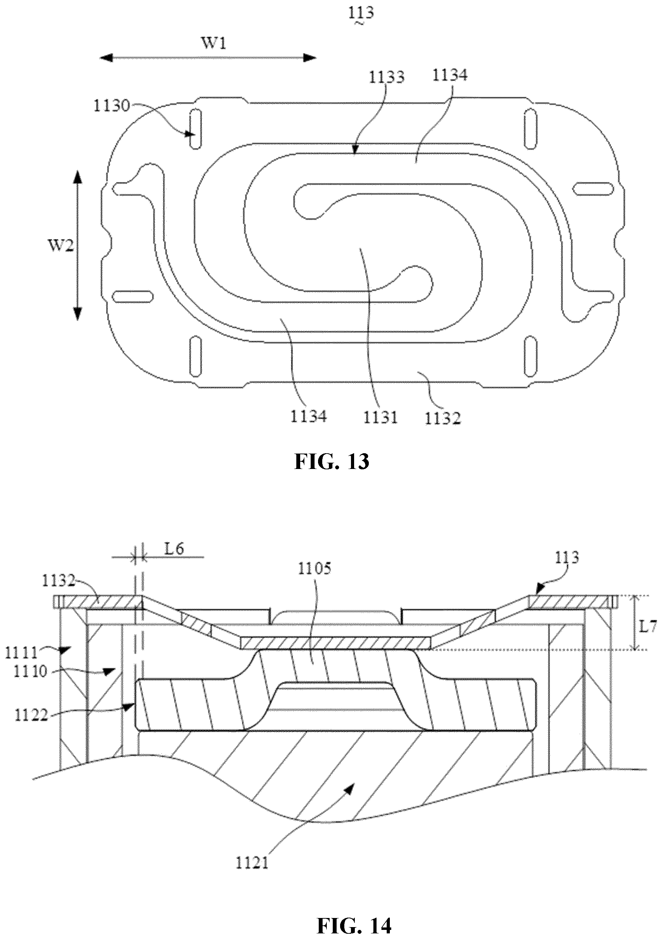

Referring to FIG. 6, FIG. 7, and FIG. 8, the bone-conducting loudspeaker 11 includes the voice coil assembly 111, the magnet assembly 112, and a vibration transmission sheet 113. The first one of the voice coil assembly 111 and the magnet assembly 112 surrounds the second one of the voice coil assembly 111 and the magnet assembly 112. For example, the voice coil assembly 111 surrounds the magnet assembly 112. As shown in FIG. 8 and FIG. 13, the vibration transmission sheet 113 includes a central fixing portion 1131, an annular fixing portion 1132 around the periphery of the central fixing portion 1131, and a linkage assembly 1133 connected between the central fixing portion 1131 and the annular fixing portion 1132. The annular fixing portion 1132 is connected to the first one of the voice coil assembly 111 and the magnet assembly 112, and the central fixing portion 1132 is connected to the second one of the voice coil assembly 111 and the magnet assembly 112. For example, the annular fixing portion 1132 is connected to the voice coil assembly 111 and the central fixing portion 1131 is connected to the magnet assembly 112. The linkage assembly 1133 is used to elastically constrain relative movement between the voice coil assembly 111 and the magnet assembly 112 along the central axis direction Z of the bone-conducting loudspeaker 11. It should be understood that the linkage assembly 1133 can maintain the stable position of the voice coil assembly 111 and the magnet assembly 112 along a radial direction perpendicular to the central axis direction Z, i.e., the linkage assembly 1133 can constrain the voice coil assembly 111 and the magnet assembly 112 along a radial direction. The relatively stable position of the voice coil assembly 111 and the magnet assembly 112 along the radial direction can render the relative movement between the two along the central axis direction Z more stable, which in turn makes the sound quality better. For example, the annular fixing portion 1132 serves as a stop member and rigidly constrains a range of relative movement between the voice coil assembly 111 and the magnet assembly 112 along the central axis direction Z (illustrated in FIG. 6). For example, the annular fixing portion 1132 is fixedly connected to the voice coil assembly 111. When used as a stop member, the magnet assembly 112 may be rigidly stopped when the vibration magnitude of the magnet assembly 112 relative to the voice coil assembly 111 is excessive, thereby limiting the movement stroke of the magnet assembly 112 and imposing a rigid constraint on the range of relative movement between the voice coil assembly 111 and the magnet assembly 112. It should be understood that the stop member may be realized in other structural forms or ways.

The central axis direction Z of the bone-conducting loudspeaker 11 may coincide with the vibration direction of the bone-conducting loudspeaker 11 (i.e., the bone-conducting vibration direction X1). The linkage assembly 1133 is an elastic member or can generate an elastic deformation that elastically constrains the voice coil assembly 111 and the magnet assembly 112. The elastic constraint may be understood as the voice coil assembly 111 and the magnet assembly 112 moving relative to each other within the range of relative movement permitted by the elastic deformation of the linkage assembly 1133. On the one hand, the linkage assembly 1133 can limit the range of relative movement between the voice coil assembly 111 and the magnet assembly 112 along the bone-conducting vibration direction X1, and on the other hand, the linkage assembly 1133 can reset the voice coil assembly 111 and the magnet assembly 112 through elastic recovery after the voice coil assembly 111 and the magnet assembly 112 have achieved relative movement. Rigidly constraining the range of relative movement between the voice coil assembly 111 and the magnet assembly 112 by the stop member along the central axis direction Z may be understood as the stop member constraining the maximum range of relative movement between the voice coil assembly 111 and the magnet assembly 112 along the central axis direction Z, preventing the relative movement between the voice coil assembly 111 and the magnet assembly 112 from exceeding the maximum range of relative movement and causing the vibration transmission sheet 113 to transition from elastic deformation to plastic deformation, resulting in a decrease in the elasticity of the vibration transmission sheet 113 and causing damage to the voice coil assembly 111 and the magnet assembly 112. Rigidity and elasticity herein are relative, i.e., the constraining strength of the stop member is greater than the constraining strength of the linkage assembly 1133.

As shown in FIG. 8, the annular fixing portion 1132 serves as a stop member, and a projection of the annular fixing portion 1132 along the central axis direction Z partially overlaps with an outer end surface 1103 of the second one of the voice coil assembly 111 and the magnet assembly 112. Specifically, the annular fixing portion 1132 is connected to the voice coil assembly 111, and the projection of the annular fixing portion 1132 along the central axis direction Z partially overlaps an outer end surface 1103 of the magnet assembly 112. By setting the projection of the annular fixing portion 1132 to partially overlap the outer end surface 1103 of the second one of the voice coil assembly 111 and the magnet assembly 112 along the central axis direction Z, when the relative movement amplitude of the voice coil assembly 111 and the magnet assembly 112 along the central axis direction Z is too large, the outer end surface 1103 of the voice coil assembly 111 and the magnet assembly 112 may abut against with the annular fixing portion 1132. Since the annular fixing portion 1132 is fixed relative to the first one of the voice coil assembly 111 and the magnet assembly 112, the annular fixing portion 1132 rigidly abuts against the second one of the voice coil assembly 111 and the magnet assembly 112, thus rigidly constraining the range of relative movement between the voice coil assembly 111 and the magnet assembly 112. For example, if the earphone 100 is subjected to the drop or collision, the relative movement amplitude of the voice coil assembly 111 and the magnet assembly 112 along the central axis direction Z may be too excessive, resulting in the vibration transmission sheet 113 transition from elastic deformation to plastic deformation, which reduces its elasticity. By applying a rigid constraint through the annular fixing portion 1132, the vibration transmission sheet 113 can be prevented from being overstretched, thereby mitigating performance degradation and reducing the impact on sound quality. In addition, providing the annular fixing portion 1132 as the stop member can eliminate the need to add an additional stopper structure, leading to a simple and stable structure with reduced costs.

Optionally, as shown in FIG. 6, FIG. 7, and FIG. 8, the outer end surface 1103 includes a center region 1104 and a peripheral region 1106 surrounding the center region 1104. The center region 1104 is provided with a protrusion portion 1105, and the protrusion portion 1105 protrudes with respect to the peripheral region 1106. The central fixing portion 1131 is fixedly connected to the protrusion portion 1105, and the projection of the annular fixing portion 1132 along the central axis direction Z partially overlaps with the peripheral region 1106.

Optionally, referring to FIG. 14, along the radial direction of the bone-conducting loudspeaker 11, a width L6 of an overlapping region between the annular fixing portion 1132 and the outer end surface 1103 is greater than or equal to 0.03 mm, thereby ensuring the constraining strength of the stop member.

Optionally, in a natural state, a spacing distance L7 between an upper surface of the protrusion portion 1105 and a lower surface of the annular fixing portion 1132 of the vibration transmission sheet 113 along the central axis direction Z is less than or equal to 1 mm. Setting the spacing distance L7 within the above range enables the linkage assembly 1133 to be reasonably pre-deformed when the central fixing portion 1131 and the protrusion portion 1105 are fixedly connected, which in turn improves the vibration efficiency of the vibration transmission sheet 113. If the spacing distance L7 is set too large, the pre-deformation amount of the linkage assembly 1133 will be excessive, making it prone to exceeding the yield limit and undergoing plastic deformation, which reduces its elastic deformation performance. Conversely, with the vibration transmission sheet 113 elastically suspended, the absence of pre-deformation would cause the relative position of the magnet assembly 112 and the voice coil assembly 111 along the central axis direction Z to deviate from the central position under the influence of gravity. This deviation would affect the relative movement between the magnet assembly 112 and the voice coil assembly 111, thereby affecting sound quality performance. In some embodiments, since the lower surface of the central fixing portion 1131 and the upper surface of the protrusion portion 1105 need to be welded in affinity, the spacing distance L7 between the upper surface of the protrusion portion 1105 and the lower surface of the annular fixing portion 1132 along the central axis direction Z may also be considered as the spacing distance between the lower surface of the central fixing portion 1131 and the lower surface of the annular fixing portion 1132.

It should be understood that whether the protrusion portion 1105 is fixed to the central fixing portion 1131 by some other structures or means, the spacing distance between the lower surface of the central fixing portion 1131 and the lower surface of the annular fixing portion 1132 along the central axis direction Z indicates the pre-deformation amount of the vibration transmission sheet 113 along the central axis direction Z.

Optionally, in a natural state, a ratio of the spacing distance between the lower surface of the central fixing portion 1131 and the lower surface of the annular fixing portion 1132 along the central axis direction Z to an extension component of the length of at least one linkage 1134 along a first direction W1 is in a range of 0 to 0.1, and the range of values includes endpoint values. Optionally, a ratio of the spacing distance between the lower surface of the central fixing portion 1131 and the lower surface of the annular fixing portion 1132 along the central axis direction Z to the extension component of the length of the at least one linkage 1134 along a second direction W2 is in a range of 0 to 0.18, and the range of values includes endpoint values. With such an arrangement, it is possible to make the vibration transmission sheet 113 be capable of pre-deformation reasonably. On the one hand, suspended components (the voice coil assembly 111 or the magnet assembly 112) can be ensured sufficiently supported without sagging to ensure the vibration performance, and on the other hand, an excellent space for elastic deformation can be guaranteed. If the ratio is too large, it is likely to result in an excessive pre-deformation amount of the vibration transmission sheet 113 that exceeds the yield limit, resulting in a decrease in elastic performance. If the ratio is too small, it is likely to lead to insufficient support of the vibration transmission sheet 113 to the suspended components, which leads to degradation of vibration performance and loss of sound quality.

Optionally, the upper surface of the protrusion portion 1105 occupies less than or equal to 30% of the area of the outer end surface 1103, and the protrusion portion 1105 occupying a smaller area can realize a more stable fixed connection with the linkage assembly 1133. In this way, it does not occupy the linkage assembly 133 excessively, but makes the linkage assembly 1133 have a sufficiently large area to generate elastic deformation, thereby providing sufficient deformation space to make the vibration transmission sheet 113 more elastic.

Optionally, as shown in FIG. 7 and FIG. 8, the magnet assembly 112 includes the magnet 1121 and two magnetic conduction plates 1122. The two magnetic conduction plates 1122 are disposed on two opposite end surfaces of the magnet 1121 along the central axis direction Z. The protrusion portion 1105 is disposed on the magnetic conduction plates 1122 such that the center region 1104 and the peripheral region 1106 are formed on an outer surface of each of the magnetic conduction plates 1122. Two projections of the two magnetic conduction plates 1122 along a radial projection of the bone-conducting loudspeaker 11 overlap with the voice coil assembly 111, respectively. The peripheral region 1106 is provided affixed to the magnet 1121, the protrusion portion 1105 is disposed spaced apart from the magnet 1121, and the peripheral region 1106 occupies more than or equal to 60% of the area on the outer end surface 1103. In this way, setting the protrusion portion 1105 can make the pre-deformation amount of the vibration transmission sheet 113 more reasonable, and can reduce the pre-deformation amount, ensuring the elastic deformation performance of the vibration transmission sheet 113. In addition, there is also no need to set up additional connection members to connect the vibration transmission sheet 113 and the magnetic conduction plate 1122, which can reduce the overall mass of the entire bone-conducting loudspeaker 11, and thus can improve the vibration effect of the bone-conducting loudspeaker 11. Optionally, when the bone-conducting loudspeaker 11 is in a normal operation state, the stop member is provided so as not to constrain the relative movement between the voice coil assembly 111 and the magnet assembly 112 along the central axis direction Z. However, when the bone-conducting loudspeaker 11 is subjected to dropping, collision, or the like, the relative movement between the voice coil assembly 111 and the magnet assembly 112 may exceed the elastic constraint range permitted by the elastic deformation of the vibration transmission sheet 113, then at this time, the stop member may rigidly constrain the relative movement between the voice coil assembly 111 and the magnet assembly 112 along the central axis direction Z, reducing the probability that the relative movement between the voice coil assembly 111 and the magnet assembly 112 exceeds the permitted elastic constraint range, thereby reducing the probability of loss of elasticity of the vibration transmission sheet 113 due to overstretching.

Optionally, as shown in FIG. 7 and FIG. 8, there are two vibration transmission sheets 113, and the two vibration transmission sheets 113 are provided on two opposite sides of the bone-conducting loudspeaker 11 along the central axis direction Z. The linkage assembly 1133 of each vibration transmission sheet 113 includes two linkages 1134. In other embodiments, the linkage assembly 1133 also includes at least two linkages 1134.

Optionally, as shown in FIG. 7 and FIG. 8, the voice coil assembly 111 surrounds the magnet assembly 112. The voice coil assembly 111 includes two sets of voice coils 1110 spaced apart along the central axis direction Z and the magnetic conduction shield 1111 around the periphery of the two sets of voice coils 1110. The magnet assembly 112 includes the magnet 1121 and two magnetic conduction plates 1122. The two magnetic conduction plates 1122 are provided on two opposite end surfaces of the magnet 1121 along the central axis direction Z. Projections of the two magnetic conduction plates 1122 along the radial direction of the bone-conducting loudspeaker 11 overlap with the two sets of voice coils 1110, respectively, and current directions of the two sets of voice coils 1110 are opposite to each other.

Optionally, the voice coil assembly 111 surrounds the magnet assembly 112, and the voice coil assembly 111 is fixed to the shell assembly 10.

Optionally, the annular fixing portion 1132 is fixedly connected to the magnetic conduction shield 1111. Optionally, the annular fixing portion 1132 and the magnetic conduction shield 1111 are welded and fixed through offset welding. Specifically, an outer edge of the annular fixing portion 1132 is offset from an outer edge of a corresponding end portion of the magnetic conduction shield 1111. For example, the outer edge of the annular fixing portion 1132 overlaps the end portion of the magnetic conduction shield 1111 and is located between the outer peripheral surface and the inner peripheral surface of the magnetic conduction shield 1111, thereby forming an offset. Based on this offset, the outer edge of the annular fixing portion 1132 and the end portion of the magnetic conduction shield 1111 are welded and fixed. By welding and fixing the annular fixing portion 1132 and the magnetic conduction shield 1111 through offset welding, the welding position is more obviously presented, which facilitates the welding process and observation of the weld seam, effectively improving welding efficiency and yield rate, thereby ensuring welding strength. For the form of welding the weld seam, it may be spot welding or continuous welding. Optionally, the weld bearing force between the annular fixing portion 1132 and the magnetic conduction shield 1111 is in a range of 400N to 1200N.

It may be appreciated that in some other embodiments of the present disclosure, the welding method may also be other methods such as lap welding (butt welding). The lap welding specifically involves stacking the annular fixing portion 1132 with the corresponding end portion of the magnetic conduction shield 1111, and welding the stacked position together using methods such as laser welding.

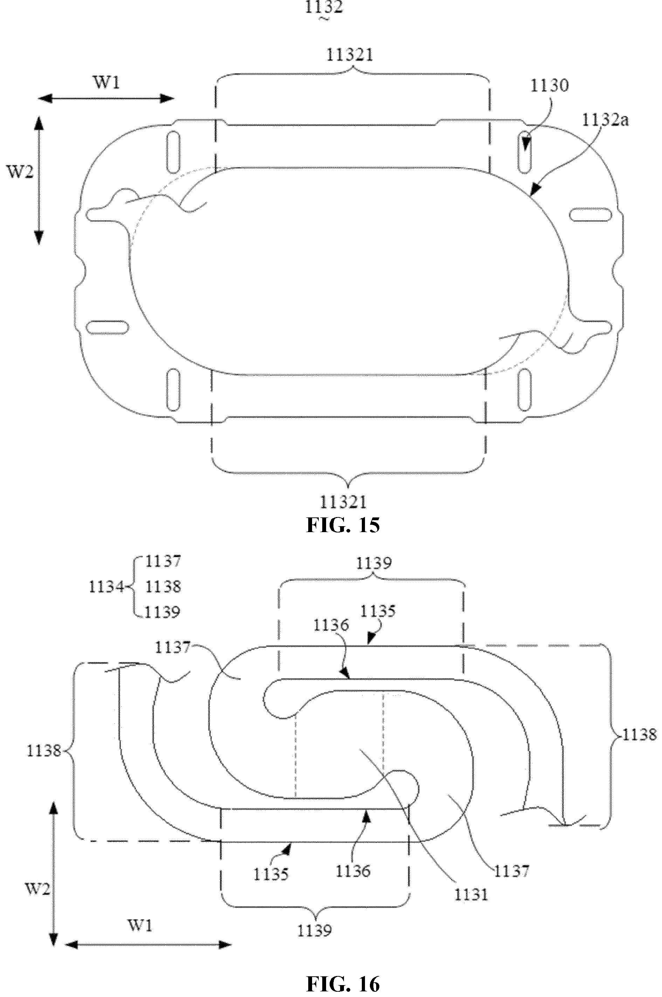

Optionally, the vibration transmission sheet 113 is provided with an observation hole 1130 penetrating through two sides of the vibration transmission sheet 113, as shown in FIG. 13 and FIG. 15. The observation hole 1130 penetrating through two sides of the vibration transmission sheet 113 refers to that the observation hole 1130 penetrate through two sides of the vibration transmission sheet 113 along a thickness direction of the vibration transmission sheet 113, and the thickness direction of the vibration transmission sheet 113 may be the central axis direction Z. Specifically, the observation hole 1130 may be formed in the annular fixing portion 1132. Optionally, there are a plurality of observation holes 1130 arranged at intervals along the circumferential direction of the vibration transmission sheet 113. By providing the observation hole 1130 on the vibration transmission sheet 113, a structure of a magnetic circuit, such as a structure of the magnet assembly 112, inside the bone-conducting loudspeaker 11 can be observed through the observation hole 1130. Besides, the observation hole 1130 can be used to understand whether the position of the magnet assembly 112 is deviated, and even the working condition of the magnet assembly 112 can be observed, which is convenient for fault troubleshooting or structural optimization, or the like.

Optionally, the vibration transmission sheet 113 includes the central fixing portion 1131 formed by sheet processing, the annular fixing portion 1132 around the periphery of the central fixing portion 1131, and the linkage assembly 1133 connected between the central fixing portion 1131 and the annular fixing portion 1132. An inner ring edge 1132a of the annular fixing portion 1132 has the first direction W1 and the second direction W2 that are perpendicular to each other. That is, the annular fixing portion 1132 has the first direction W1 and the second direction W2. The linkage assembly 1133 is composed of two linkages 1134, each of the linkages 1134 has an outer edge 1135 toward the inner ring edge 1132a, and an inner edge 1136 away from the inner ring edge 1132a. An extension component of the outer edge 1135 along the first direction W1 is greater than or equal to one-half of a dimension of the inner ring edge 1132a along the first direction W1, and the width of the linkage 1134 is greater than or equal to one-tenth of a dimension of the inner ring edge 1132a along the second direction W2.

Specifically, the above description is illustrated in a case where the central fixing portion 1131, the annular fixing portion 1132, and the linkage assembly 1133 are set up coplanar. In the case where there are distortion points such as protrusions or grooves at the inner ring edge 1132a, these distortion points should be eliminated, and a smooth linear transition should be formed on the outside of the distortion points to create the inner ring edge 1132a. For example, the second direction W2 refers to a direction in which the shortest line segment intersecting the inner ring edge 1132a over the geometric center of the inner ring edge 1132a is located. The first direction W1 refers to a direction that is perpendicular to the second direction W2 in the plane in which the central fixing portion 1131, the annular fixing portion 1132, and the linkage assembly 1133 are located. The vibration transmission sheet 113 is provided as a two-linkage structure, and an extension component of the outer edge 1135 along the first direction W1 is greater than or equal to one-half of the dimension of the inner ring edge 1132a along the first direction W1. In this way, the extension length of the linkage 1134 can be increased, which makes the linkage 1134 has a larger deformation space. At the same time, since the width of the linkage 1134 is greater than or equal to one-tenth of the dimension of the inner ring edge 1132a along the second direction W2, it can improve the resistance as well as the service life of the linkage 1134.

Optionally, the extension component of the outer edge 1135 along the first direction W1 is further greater than or equal to two-thirds of the dimension of the inner ring edge 1132a along the first direction W1. Therefore, the extension component of the outer edge 1135 along the first direction W1 is further greater than or equal to two-thirds of the dimension of the inner ring edge 1132a along the first direction W1, which may further increase the extension length of the linkage 1134 and allows the linkage 1134 to have a greater deformation space.

Optionally, the extension component of the outer edge 1135 along the second direction W2 is greater than or equal to one-half of the dimension of the inner ring edge 1132a along the second direction W2. Therefore, the extension component of the outer edge 1135 along the second direction W2 is greater than or equal to one-half of the dimension of the inner ring edge 1132a along the second direction W2, which may further increase the extension length of the linkage 1134 and allows the linkage 1134 to have a larger deformation space.

Optionally, the extension component of the outer edge 1135 along the second direction W2 is greater than or equal to two-thirds of the dimension of the inner ring edge 1132a along the second direction W2. Therefore, the extension component of the outer edge 1135 along the second direction W2 is greater than or equal to two-thirds of the dimension of the inner ring edge 1132a along the second direction W2, which can further increase the extension length of the linkage 1134 and allows the linkage 1134 to have a larger deformation space.

Optionally, the width of the linkage 1134 is greater than or equal to one-eighth of the dimension of the inner ring edge 1132a along the second direction W2. Therefore, the width of the linkage 1134 is greater than or equal to one-eighth of the dimension of the inner ring edge 1132a along the second direction W2, which can further improve the resistance as well as the service life of the linkage 1134.

Optionally, the two linkages 1134 are rotationally symmetrical at 180 degrees centered on the central fixing portion 1131. With this setup, the vibration transmission stability and balance of the vibration transmission sheet 113 can be effectively improved.

Optionally, the dimension of the inner ring edge 1132a along the first direction W1 is larger than the dimension of the inner ring edge 1132a along the second direction W2. In other words, the annular fixing portion 1132 may be provided in a general runway shape. A ratio of the dimension of the inner ring edge 1132a along the first direction W1 to the dimension of the inner ring edge 1132a along the second direction W2 is greater than or equal to 1.5.

Optionally, along the first direction W1, two linkages 1134 connect to two opposite sides of the central fixing portion 1131. With this setup, it is possible to increase the length of the linkages 1134 effectively. Specifically, as shown in FIG. 15, the inner ring edge 1132a includes two edge segments 11321 spaced apart along the second direction W2. Each of the linkages 1134 is provided to start at the central fixing portion 1131, to extend through a gap between the central fixing portion 1131 and one of the two inner ring edges 1132a, and to be connected to the other of the two edge segments 11321.

Optionally, one end of the linkage 1134 is smoothly connected to the central fixing portion 1131. Another end of the linkage 1134 is smoothly connected to the annular fixing portion 1132. Further, as shown in FIG. 16, the linkage 1134 includes a first sub-linkage portion 1137 connected to the central fixing portion 1131, a second sub-linkage portion 1138 connected to the annular fixing portion 1132 and a third sub-linkage portion 1139 connected between the first sub-linkage portion 1137 and the second sub-linkage portion 1138. At least a portion of the first sub-linkage portion 1137 is progressively wider in a direction toward the central fixing portion 1131 and smoothly connected to the central fixing portion 1131, at least a portion of the second sub-linkage portion 1138 is progressively wider in a direction toward the annular fixing portion 1132 and smoothly connected to the annular fixing portion 1132, and the third sub-linkage portion 1139 remains uniform in width.

Optionally, the inner edge 1136 of the first sub-linkage portion 1137 and the inner edge 1136 of the second sub-linkage portion 1138 are provided in an arcuate shape. The inner edge 1136 of the third sub-linkage portion 1139 is provided in a straight line and is in smooth transition with the inner edge 1136 of the first sub-linkage portion 1137 and the inner edge 1136 of the second sub-linkage portion 1138, and/or the outer edge 1135 of the first sub-linkage portion 1137 and the outer edge 1135 of the second sub-linkage portion 1138 are provided in an arcuate shape, and the outer edge 1135 of the third sub-linkage portion 1139 is provided in a straight line and is in a smooth transition with the outer edge 1135 of the first sub-linkage portion 1137 and the outer edge 1135 of the second sub-linkage portion 1138. Such a setting can effectively reduce the internal stress at the connection point between the linkage 1134 and the central fixing portion 1131 and the connection point between the linkage 1134 and the annular fixing portion 1132.

Optionally, a portion of the second sub-linkage portion 1138 that is connected to the third sub-linkage portion 1139 is aligned with the width of the third sub-linkage portion 1139 and/or a portion of the first sub-linkage portion 1137 that is connected to the third sub-linkage portion 1139 is aligned with the width of the third sub-linkage portion 1139.

Optionally, an extension component of the outer edge 1135 of the third sub-linkage portion 1139 along the first direction W1 is greater than or equal to one-half of the dimension of the inner ring edge 1132a along the first direction W1, and the width of the third sub-linkage portion 1139 is greater than 0.5 mm.

Optionally, the inner edge 1136 of the first sub-linkage portion 1137 is provided as a concave arc, and an edge of the central fixing portion 1131 that is connected to the inner edge 1136 of the first sub-linkage portion 1137 is provided as a convex arc, forming a smooth transition with the inner edge 1136 of the first sub-linkage portion 1137. Set up in this way, on the one hand, it is possible to make a reasonable transition between the central fixing portion 1131 and the first sub-linkage portion 1137, and on the other hand, the convex arc setting can ensure the dimension of the central fixing portion 1131, and thus ensure the fixing effect of the central fixing portion 1131 and the magnet assembly 112.

Optionally, the bone-conducting loudspeaker 11 includes two vibration transmission sheets 113. The two vibration transmission sheets 113 are provided on two opposite sides of the bone-conducting loudspeaker 11 along the central axis direction Z, respectively. The extension direction of the linkage assembly 1133 of the first one of the two vibration transmission sheets 113, starting from the connected central fixing portion 1131, is opposite to the extension direction of the linkage assembly 1133 of the second one of the two vibration transmission sheets 113, which also starts from the connected central fixing portion 1131. With this setup, the moment of inertia around the bone-conducting vibration direction X1 can be offset when the bone-conducting loudspeaker 11 vibrates along the bone-conducting vibration direction X1.

Optionally, the magnet assembly 112 is less than or equal to 80% of the mass of the bone-conducting loudspeaker 11, and the mass of the load pushed by the bone-conducting loudspeaker 11 is less than or equal to 9 times the mass of the bone-conducting loudspeaker 11. The load pushed by the bone-conducting loudspeaker 11 includes the sum of the masses of the shell assembly 10 and the parts within the shell assembly 10 other than the magnet assembly 112.

Optionally, the mass of the bone-conducting loudspeaker 11 is less than or equal to 8 grams.

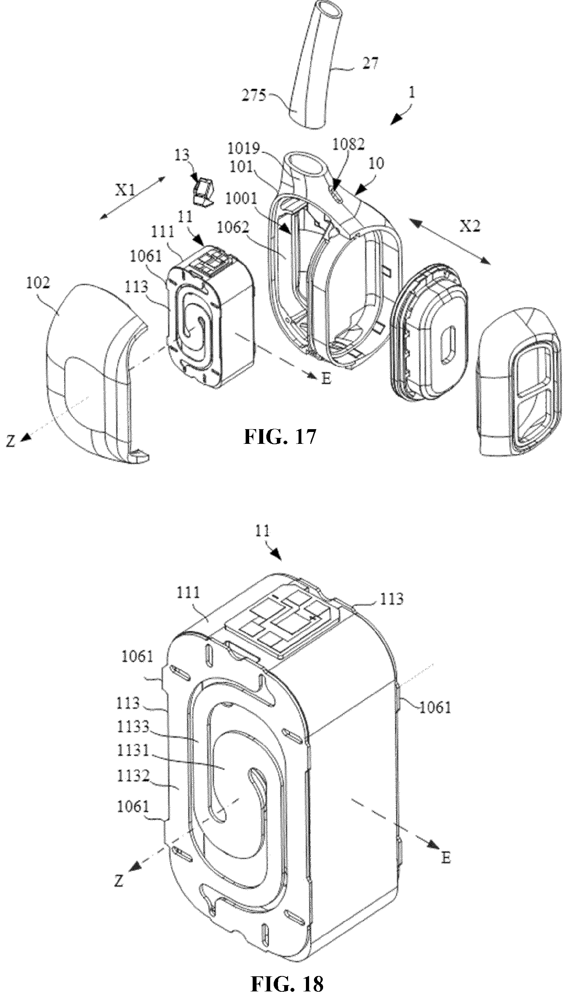

Optionally, the vibration transmission sheet 113 is set such that the earphone 100 has a resonance peak, with the peak of the resonance peak being less than or equal to 500 Hz. Referring to FIG. 3 and FIG. 17, the core assembly 1 includes the shell assembly 10, the bone-conducting loudspeaker 11, and a fixing adhesive 1062. The shell assembly 10 is used to accommodate the bone-conducting loudspeaker 11. The fixing adhesive 1062 is used to fix the bone-conducting loudspeaker 11 to the shell assembly 10. Specifically, the shell assembly 10 is provided with the accommodation cavity 1001. The bone-conducting loudspeaker 11 may be accommodated within the accommodation cavity 1001, and the bone-conducting loudspeaker 11 is provided to vibrate along the central axis direction Z of the bone-conducting loudspeaker 11. The portion of the shell assembly 10 corresponding to the bone-conducting loudspeaker 11 is fitted to the user's face, and the bone-conducting loudspeaker 11 can drive the shell assembly 10 to vibrate when vibrating, converting an electrical signal into a vibration signal and transmitting the vibration signal to the auditory nerve through the human tissues. The central axis direction Z of the bone-conducting loudspeaker 11 is shown in direction Z in FIG. 17.

As shown in FIG. 3 and FIG. 17, the earphone 100 further includes the wearing assembly 27. The shell 101 and the shell 102 fit with each other to form the accommodation cavity 1001, the shell 101 is connected to the wearing assembly 27, and the fixing adhesive 1062 connects the shell 101 to the bone-conducting loudspeaker 11. Fitting the shell 101 and the shell 102 to form the accommodation cavity 1001 can facilitate the earphone 100 to be installed with the wearing assembly 27 and the bone-conducting loudspeaker 11 during production, reduce the difficulty of the production of the earphone 100, and also facilitate the subsequent disassembly and maintenance of the earphone 100. The core assembly 1 includes the shell assembly 10 and a microphone assembly 13. The microphone assembly 13 is accommodated within the accommodation cavity 1001. As shown in FIG. 17, the shell assembly 10 is provided with a sound inlet hole 1082, and the microphone assembly 13 is configured to capture an external sound input via the sound inlet hole 1082.

For example, the wearing assembly 27 includes elements such as an ear-hook, a headband, a clip, or the like, to facilitate wearing and fixing the earphone 100 in a position via the wearing assembly 27. Optionally, the wearing assembly 27 is disposed on the shell 101 along a radial direction of the bone-conducting loudspeaker 11 such that the wearing assembly 27 does not interfere with the vibration effect brought about by the bone-conducting loudspeaker 11 along the central axis direction Z.

As shown in FIG. 7, the voice coil assembly 111 surrounds the magnet assembly 112, and the vibration transmission sheet 113 is elastically connected to the voice coil assembly 111 and the magnet assembly 112 to elastically constrain the relative movement between the voice coil assembly 111 and the magnet assembly 112 along the central axis direction Z. The fixing adhesive 1062 connects the shell assembly 10 and the voice coil assembly 111.

Specifically, the voice coil assembly 111 may interact with the magnet assembly 112 while current is passing through the voice coil assembly 111, thereby generating vibration. Therefore, by controlling the current passing through the voice coil assembly 111, the voice coil assembly 111 may interact with the magnet assembly 112 to generate corresponding vibration signals, and the vibration signals may be further transmitted to the shell assembly 10 and then to human tissues.

The vibration transmission sheet 113 is elastically connected to the voice coil assembly 111 and the magnet assembly 112 and can elastically constrain the voice coil assembly 111 and the magnet assembly 112, so that when the voice coil assembly 111 generates vibration, the voice coil assembly 111 and the magnet assembly 112 are less likely to move relative to each other along the central axis direction Z, thereby ensuring the stability of the earphone 100.

Optionally, the fixing adhesive 1062 connects the shell 101 and the voice coil assembly 111. Specifically, the inner peripheral surface of the shell 101 and an outer peripheral surface of the voice coil assembly 111 may be opposite to each other, and the fixing adhesive 1062 may be filled in a gap between the inner peripheral surface of the shell 101 and the outer peripheral surface of the voice coil assembly 111 to connect and fix the shell 101 and the voice coil assembly 111.

Optionally, the shell 101 and the shell 102 may fit along the central axis direction Z, and the shell 102 further presses and fixes the voice coil assembly 111 to the shell 101. In this way, by using the shell 102 to further press and fix the voice coil assembly 111 to the shell 101, it is possible to further stabilize the position of the voice coil assembly 111 along the central axis direction Z. The shell 101 and shell 102 fitting to further press and fix the voice coil assembly 111 reduces the need for additional fixing means, and also makes it easier for the voice coil assembly 111 to drive the shell assembly 10 to vibrate when it vibrates along the central axis direction Z, thereby improving the structural tightness of the earphone 100.

As previously described, there may be two sets of voice coils 1110, with the magnetic conduction shield 1111 around the periphery of the two sets of voice coils 1110. The two sets of voice coils 1110 are available for the passage of current for vibration by interacting with the magnet assembly 112 as the current passes. Besides, providing the two sets of voice coils 1110 spaced apart along the central axis direction Z enables a stronger vibration of the voice coil assembly 111.

The magnetic conduction shield 1111 is used to constrain the magnetic field direction of the magnet assembly 112, and is also used to contact the shell assembly 10. When the two sets of voice coils 1110 vibrate, the magnetic conduction shield 1111 can be driven to vibrate to transmit the vibration signals to the shell assembly 10 through the magnetic conduction shield 1111.

As previously described, there may be two magnetic conduction plates 1122, and the two magnetic conduction plates 1122 may be disposed on two opposite end surfaces of the magnet 1121 along the central axis direction Z, respectively. The two magnetic conduction plates 1122 are used to constrain the magnetic field direction of the magnet 1121 on two opposite end surfaces of the magnet 1121 along the central axis direction Z, thereby enhancing the effect of the interaction between the magnet 1121 and the voice coils 1110. Optionally, projections of the two magnetic conduction plates 1122 along a radial direction E overlap with the two voice coils 1110, ensuring that the magnetic conduction plates 1122 can act on the two voice coils 1110. The current directions of the two sets of voice coils 1110 are opposite to ensure that the two voice coils 1110 are subjected to the same direction of force under the interaction of the same magnet 1121.

A locating portion 1061 may be provided on the shell assembly 10 and/or the bone-conducting loudspeaker 11 as illustrated in FIG. 17 to FIG. 19. The locating portion 1061 is configured to maintain a predetermined gap between an inner peripheral surface of the shell assembly 10 and an outer peripheral surface of the bone-conducting loudspeaker 11 along a radial direction of the bone-conducting loudspeaker 11. The radial direction of the bone-conducting loudspeaker 11 is shown in the direction E in FIG. 17 to FIG. 19. Directions perpendicular to the central axis direction Z are all referred to as the radial direction E of the bone-conducting loudspeaker 11.

The position of the locating portion 1061 may be disposed on the shell assembly 10, on the bone-conducting loudspeaker 11, or on both the shell assembly 10 and the bone-conducting loudspeaker 11, which is not limited by the present disclosure herein. For example, the locating portion 1061 may be disposed on one of the shell assembly 10 or the bone-conducting loudspeaker 11, and is positioned against another one of the shell assembly 10 or the bone-conducting loudspeaker 11 along a radial direction of the bone-conducting loudspeaker 11, thus forming a gap between the inner peripheral surface of the shell assembly 10 and the outer peripheral surface of the bone-conducting loudspeaker 11.

The fixing adhesive 1062 may fill in the gap and connect the shell assembly 10 and the bone-conducting loudspeaker 11. This allows the fixing adhesive 1062 to fix the shell assembly 10 and the bone-conducting loudspeaker 11 along a circumferential direction of the bone-conducting loudspeaker 11, so that the bone-conducting loudspeaker 11 is less prone to deflection when vibrating along the central axis direction Z.

Maintaining the predetermined gap between the bone-conducting loudspeaker 11 and the shell assembly 10 along the circumferential direction of the bone-conducting loudspeaker 11 facilitates the addition of the fixing adhesive 1062, simplifies the production process of the earphone 100, and facilitates the flow of the fixing adhesive 1062 along the circumferential direction of the bone-conducting loudspeaker 11, which enables it to be uniformly filled in the gap between the bone-conducting loudspeaker 11 and the shell assembly 10. In this way, the fixing effect of the fixing adhesive 1062 can be improved, thus stabilizing the position of the bone-conducting loudspeaker 11 in the accommodation cavity 1001, thereby making the structure of the earphone 100 more compact and stable.

Optionally, there may be a plurality of locating portions 1061, and the plurality of locating portions 1061 are spaced apart along the circumferential direction of the bone-conducting loudspeaker 11. The plurality of locating portions 1061 are spaced apart along the circumferential direction of the bone-conducting loudspeaker 11, and the plurality of locating portions 1061 locate predetermined gaps along the circumferential direction of the bone-conducting loudspeaker 11 to facilitate application of the fixing adhesive 1062 along the circumferential direction of the bone-conducting loudspeaker 11, thereby enhancing the fixation effect of the fixing adhesive 1062. Optionally, the plurality of locating portions 1061 may be symmetrically arranged on two opposite sides of the bone-conducting loudspeaker 11 along the circumferential direction.

As shown in FIG. 18, the vibration transmission sheet 113 may elastically constrain the relative movement between the voice coil assembly 111 and the magnet assembly 112 along the central axis direction Z. Optionally, the central fixing portion 1131 is fixedly connected to the magnetic conduction plate 1122, the annular fixing portion 1132 is fixedly connected to the magnetic conduction shield 1111, and the linkage assembly 1133 connects the annular fixing portion 1132 and the central fixing portion 1131.

Specifically, the locating portion 1061 is disposed at an outer ring edge of the annular fixing portion 1132 of the vibration transmission sheet 113 and extends along the radial direction of the bone-conducting loudspeaker 11 toward the inner peripheral surface of the shell assembly 10 for abutting against the inner peripheral surface of the shell assembly 10, such that a predetermined gap can be maintained between the inner peripheral surface of the shell assembly 10 and the outer peripheral surface of the bone-conducting loudspeaker 11 along the radial direction of the bone-conducting loudspeaker 11, enabling the fixing adhesive 1062 to be filled within the gap. By disposing the locating portion 1061 on the vibration transmission sheet 113 can facilitate the machining out of the locating portion 1061 through a simple machining process. Besides, the vibration of the vibration transmission sheet 113 is mainly along the central axis direction Z and relies on elastic deformation generated by the linkage assembly 1133, on the one hand, disposing the locating portion 1061 at the outer ring edge of the annular fixing portion 1132 may not affect the elastic deformation of the linkage assembly 1133, ensuring the vibration and sound quality effect of the bone-conducting loudspeaker 11, and on the other hand, it can also enhance the strength of the annular fixing portion 1132, and the smaller displacement and the relatively fixed position of the annular fixing portion 1132 can better support the inner peripheral surface of the shell assembly 10 and can more stably maintain the predetermined gap.

As previously described, there may be two vibration transmission sheets 113, and the two vibration transmission sheets 113 are provided on two opposite sides of the bone-conducting loudspeaker 11 along the central axis direction Z. The locating portions 1061 may be disposed at the outer ring edge of the annular fixing portion 1132 of the two vibration transmission sheets 113, respectively, which can make the force of the bone-conducting loudspeaker 11 more uniform. Along the central axis direction Z of the bone-conducting loudspeaker 11, the gap between the inner peripheral surface of the shell assembly 10 and the outer peripheral surface of the bone-conducting loudspeaker 11 may be of a consistent width, which can enable the bone-conducting loudspeaker 11 to be set in a more accurate position and also enhance the filling effect of the fixing adhesive 1062.

In some embodiments, the locating portion 1061 is disposed at the outer ring edge of the annular fixing portion 1132 of the vibration transmission sheet 113, which also improves the assembly and positioning of the vibration transmission sheet 113 when it is fixed to the magnet assembly 112 and the magnetic conduction shield 1111 with a better locating accuracy, which in turn ensures that a magnetic gap between the magnetic conduction shield 1111 fixed with the voice coil 1110 and the magnet assembly 112 more uniform and balanced, thereby improving the sound quality. For example, the bone-conducting loudspeaker 11 can be assembled using an upper jig and a lower jig as follows: the magnet assembly 112 and the magnetic conduction shield 1111 fixed with the voice coil 1110 are located using the lower jig, while the vibration transmission sheet 113 is located using the upper jig. In this way, the vibration transmission sheet 113 can be located using the locating portion 1061, and the upper jig can be designed with holes to facilitate the welding of the vibration transmission sheet 113 to the magnet assembly 112 and the magnetic conduction shield 1111, which also ensures the alignment of corresponding positions on the vibration transmission sheet 113 (e.g., the central fixing portion 1131) with the corresponding holes on the upper jig. Then, the upper jig and the lower jig are aligned to ensure that the corresponding positions on the vibration transmission sheet 113 (e.g., the central fixing portion 1131) align with the corresponding positions on the magnet assembly 112 (e.g., the protrusion portion 1105). Similarly, the corresponding positions on the vibration transmission sheet 113 (e.g., the annular fixing portion 1132) align with the corresponding positions on the magnetic conduction shield 1111. This alignment allows for subsequent operations through the holes in the upper jig, such as pre-deforming the vibration transmission sheet 113 and fixing the vibration transmission sheet 113, the magnetic conduction shield 1111, and the magnet assembly 112 together.

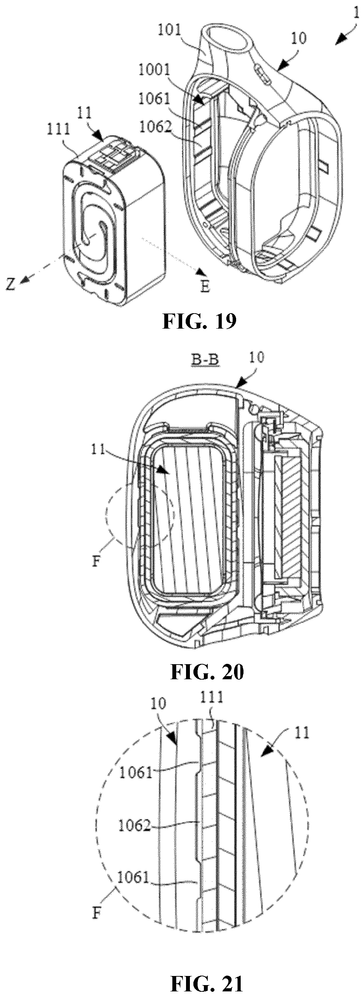

As shown in FIG. 19 to FIG. 21, the locating portion 1061 may also be integrally molded to the inner peripheral surface of the shell assembly 10.

In some embodiments, a plurality of locating portions 1061 may be spaced apart on an inner peripheral surface of the shell assembly 10. The plurality of locating portions 1061 may be spaced apart on the shell assembly 10, extend towards the bone-conducting loudspeaker 11, and abut against the outer peripheral surface of the bone-conducting loudspeaker 11 to support a gap between the inner peripheral surface of the shell assembly 10 and the outer peripheral surface of the bone-conducting loudspeaker 11. Optionally, the plurality of locating portions 1061 may be integrally molded to the inner peripheral surface of the shell 101. By providing the locating portions 1061 on the inner peripheral surface of the shell assembly 10, on the one hand, it can locate the bone-conducting loudspeaker 11 when assembling the bone-conducting loudspeaker 11, which facilitates its assembly, on the other hand, since the locating portion 1061 is disposed on the inner peripheral surface of the shell assembly 10, its position is stable and is not affected by the vibration of the bone-conducting loudspeaker 11, and thus the predetermined gap can be stably maintained. Moreover, by disposing the locating portion 1061 on the shell assembly 10, the bone-conducting loudspeaker 11 can be minimized and facilitate the vibration of the bone-conducting loudspeaker 11, and by setting the locating portion 1061 on the shell assembly 10 abutting against the bone-conducting loudspeaker 11, the vibration transmission of the bone-conducting loudspeaker 11 to the shell assembly 10 can be further ensured, thereby ensuring the sound quality effect of the bone-conducting loudspeaker 11. Moreover, locating on the shell assembly 10 is relatively simple to process, which can streamline the manufacturing process of the locating portion 1061 and, in turn, reduce the overall manufacturing complexity of the earphone 100.

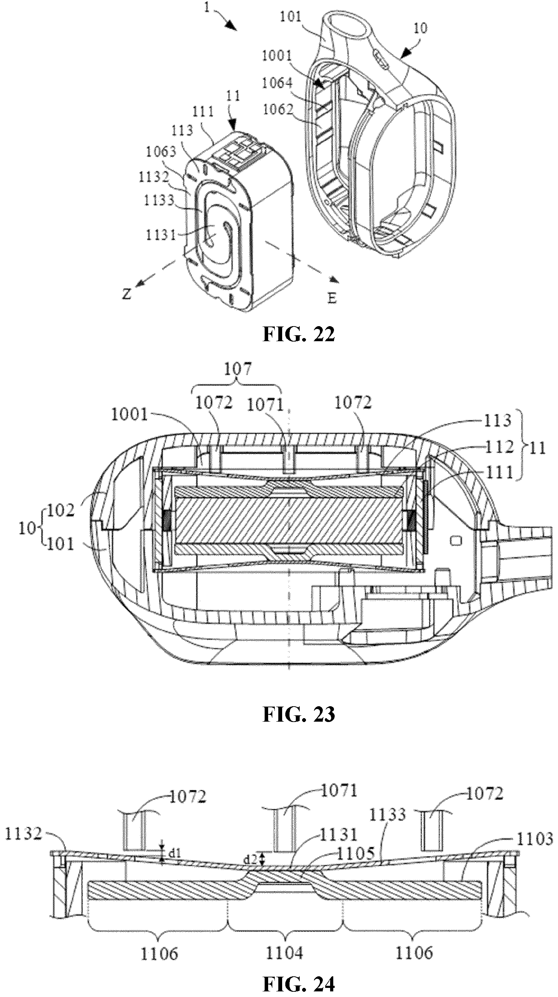

In other embodiments, as illustrated in FIG. 22, the locating portion 1061 includes a first locating portion 1063 integrally molded to the outer ring edge of the annular fixing portion 1132 and a second locating portion 1064 integrally molded to the inner peripheral surface of the annular fixing portion 1132. The first locating portion 1063 is disposed on the annular fixing portion 1132 and extends along the radial direction E of the bone-conducting loudspeaker 11 to abut against the inner peripheral surface of the shell assembly 10. The second locating portion 1064 is disposed on the inner peripheral surface of the shell assembly 10 and extends along the radial direction E of the bone-conducting loudspeaker 11 to abut against the outer peripheral surface of the bone-conducting loudspeaker 11. It should be understood that the first locating portion 1063 may not be limited to being disposed on the annular fixing portion 1132, but may also be disposed on the outer peripheral surface of the bone-conducting loudspeaker 11 such as the outer peripheral surface of the voice coil assembly 111.

Both the bone-conducting loudspeaker 11 and the shell assembly 10 are provided with the locating portions 1061 to realize a bidirectional abut along the radial direction E, so that even if the locating portion 1061 on one of the sides is not effective in supporting the bone-conducting loudspeaker 11, the locating portion 1061 on another side can ensure the support effect, which in turn enhances the redundancy and further stabilizes the position of the bone-conducting loudspeaker 11. In this way, the locating portion 1061 can more securely support the gap between the inner peripheral surface of the shell assembly 10 and the outer peripheral surface of the bone-conducting loudspeaker 11, to facilitate the addition of the fixing adhesive 1062 and to make the force of the bone-conducting loudspeaker 11 more even, thus making the structure of the earphone 100 more stable.

Optionally, the first locating portion 1063 and the second locating portion 1064 are staggered from each other along the circumferential direction of the bone-conducting loudspeaker 11. Such an arrangement facilitates the assembly of the bone-conducting loudspeaker 11 into the shell assembly 10, reduces friction and damage caused by the first locating portion 1063 and the second locating portion 1064 due to coming into contact with each other, and further stabilizes the position of the bone-conducting loudspeaker 11 and enhance the structural tightness of the earphone 100.

Referring to FIG. 23, the shell assembly 10 includes the accommodation cavity 1001. The bone-conducting loudspeaker 11 is accommodated within the accommodation cavity 1001. The vibration transmission sheet 113 may connect the voice coil assembly 111 and the magnet assembly 112 and elastically constrain the relative movement between the voice coil assembly 111 and the magnet assembly 112 along the central axis direction Z of the bone-conducting loudspeaker 11. First one of the voice coil assembly 111 and the magnet assembly 112 is rigidly connected to the shell assembly 10, which in turn can transmit vibrations generated by the relative movement between the voice coil assembly 111 and the magnet assembly 112 to the shell assembly 10 for realizing bone conduction.

Specifically, the first one of the voice coil assembly 111 and the magnet assembly 112 refers to the voice coil assembly 111 and the second one of the voice coil assembly 111 and the magnet assembly 112 refers to the magnet assembly 112. In this case, the voice coil assembly 111 may be rigidly connected to the shell assembly 10. In other embodiments, the first one of the voice coil assembly 111 and the magnet assembly 112 also refers to the magnet assembly 112, and the second one of the voice coil assembly 111 and the magnet assembly 112 refers to the magnet assembly 112.

As previously described, the central fixing portion 1131 may be connected to the magnet assembly 112 and the annular fixing portion 1132 may be connected to the voice coil assembly 111. The vibration transmission sheet 113 may be inherently elastic or may be subject to elastic deformation. The vibration transmission sheet 113 may adaptively deform elastically when the voice coil assembly 111 and the magnet assembly 112 move relative to each other. While the vibration transmission sheet 113 adaptively deforms elastically, the central fixing portion 1131 connecting the magnet assembly 112 and the annular fixing portion 1132 connecting the voice coil assembly 111 may move relative to each other along the central axis direction Z.

Usually, when the earphone 100 outputs sound normally, the range of relative movement between the magnet assembly 112 and the voice coil assembly 111 is within a permitted range, i.e., the relative movement between the two is realized through the elastic deformation generated by the vibration transmission sheet 113. However, in some special scenarios, the range of relative movement between the magnet assembly 112 and the voice coil assembly 111 may exceed the permitted range. For example, when the earphone 100 falls to the ground or collide, the magnet assembly 112 continues to move due to inertia, resulting in an excessive displacement of the magnet assembly 112 relative to the voice coil assembly 111, thereby exerting excessive force on the vibration transmission sheet 113. Consequently, the vibration transmission sheet 113 may be overstretched, potentially exceed its range of elastic deformation, and undergo plastic deformation, which would reduce its elasticity, weaken the elastic constraint effect, and ultimately affect the performance of the earphone 100.

To ameliorate the above-mentioned problems, the shell assembly 10 may be provided with the stop member 107. The stop member 107 may rigidly constrain the range of relative movement between the voice coil assembly 111 and the magnet assembly 112 along the central axis direction Z. That is to say, the stop member 107 may apply a rigid constraint to the magnet assembly 112 when the magnet assembly 112 moves excessively compared to the voice coil assembly 111, to limit the movement amplitude of the magnet assembly 112, which in turn can reduce the elasticity degradation of the vibration transmission sheet 113 caused by the excessive movement amplitude.

Setting the stop member 107 to limit the range of relative movement between the voice coil assembly 111 and the magnet assembly 112 can avoid an excessively large range of relative movement between the voice coil assembly 111 and the magnet assembly 112 or reduce the possibility of an excessively large range of relative movement between the voice coil assembly 111 and the magnet assembly 112, thereby minimizing the possibility of overstretching the vibration transmission sheet 113.

The rigid constraint imposed by the stop member 107 and the elastic constraint imposed by the vibration transmission sheet 113 are relative to each other, i.e., the constraining strength exerted by the stop member 107 on the magnet assembly 112 when stopping the magnet assembly 112 is greater than the constraining strength exerted by the vibration transmission sheet 113 on the magnet assembly 112 and the voice coil assembly 111.

Optionally, the stop member 107 protrudes from the shell assembly 10. The first one of the voice coil assembly 111 and the magnet assembly 112 may be fixedly connected to the shell assembly 10, and the stop member 107 is disposed on a surface of the shell assembly 10 towards the second one of the voice coil assembly 111 and the magnet assembly 112 along the central axis direction Z. The stop member 107 may be fixedly connected to the second one of the voice coil assembly 111 and the magnet assembly 112 or abut against the vibration transmission sheet 113 after the second one of the voice coil assembly 111 and the magnet assembly 112 moves a predetermined distance relative to the first one of the voice coil assembly 111 and the magnet assembly 112, which in turn can effectively limit the range of relative movement between the voice coil assembly 111 and the magnet assembly 112.

For example, the voice coil assembly 111 is fixedly connected to the shell assembly 10, and the stop member 107 may abut against the magnet assembly 112 or the vibration transmission sheet 113 after the magnet assembly 112 moves to a predetermined distance relative to the voice coil assembly 111, thereby imposing a rigid constraint on the magnet assembly 112 or the vibration transmission sheet 113. This makes it possible to limit the range of relative movement between the voice coil assembly 111 and the magnet assembly 112.

In other embodiments, the stop member 107 may also be in the form of a plate or other arbitrary shape.

Optionally, the stop member 107 is integrally molded to the shell assembly 10, which can improve productivity and assembly efficiency.

The stop member 107 may apply a rigid constraint to the magnet assembly 112 directly or indirectly after the magnet assembly 112 moves a predetermined distance relative to the voice coil assembly 111. Optionally, the stop member 107 applies the rigid constraint to the magnet assembly 112 indirectly by applying the rigid constraint directly on the vibration transmission sheet 113.

Referring to FIG. 24, the stop member 107 may abut against the central fixing portion 1131 of the vibration transmission sheet 113 and/or the linkage assembly 1133 to apply a rigid constraint on the vibration transmission sheet 113.

Optionally, the stop member 107 includes a first stop member 1071 for abutting against the central fixing portion 1131. The first stop member 1071 may effectively limit the vibration range of the vibration transmission sheet 113 and thus limit the range of relative movement between the voice coil assembly 111 and the magnet assembly 112.

Optionally, the stop member 107 includes a second stop member 1072 for abutting against the linkage assembly 1133. The second stop member 1072 may fit with the first stop member 1071 to allow the stop member 107 and the vibration transmission sheet 113 to be abutted against each other to a greater extent, so as to more contact the vibration transmission sheet 113 and further protect the vibration transmission sheet 113.

Optionally, there may be at least one first stop member 1071. Optionally, there may be at least two second stop members 1072.

During vibration of the vibration transmission sheet 113, the moveable distance of a region near the center of the vibration transmission sheet 113 (e.g., the central fixing portion 1131) is greater than the moveable distance of a region away from the center of the vibration transmission sheet 113. If the first stop member 1071 and the second stop member 1072 are at the same distance from the bone-conducting loudspeaker 11 while the movement degrees in different regions of the vibration transmission sheet 113 are different, the first stop member 1071 and the second stop member 1072 may not simultaneously abut against the vibration transmission sheet 113, which makes the rigid constraint less effective.

Optionally, the vibration transmission sheet 113 may be configured with a pre-deformation design, i.e., in a natural state, the linkage assembly 1133 has an extension component starting at the annular fixing portion 1132 and pointing toward the interior of the bone-conducting loudspeaker 11 along the central axis direction Z. The vibration transmission sheet 113 may be pre-deformed toward the interior of the bone-conducting loudspeaker 11 or may be pre-deformed toward the exterior of the bone-conducting loudspeaker 11. The natural state refers to a state when the bone-conducting loudspeaker 11 is assembled or a state in which the voice coil assembly 111 and the magnet assembly 112 are relatively stationary when the bone-conducting loudspeaker 11 is not operating.

Along the central axis direction Z, a spacing d2 from the first stop member 1071 to the central fixing portion 1131 is greater than a spacing d1 from the second stop member 1072 to the linkage assembly 1133. In this way, the possibility of the first stop member 1071 and the second stop member 1072 simultaneously abutting against the vibration transmission sheet 113 can be increased, which facilitates the first stop member 1071 and the second stop member 1072 to jointly exert a rigid constraint on the vibration transmission sheet 113. Alternatively, as compared to the spacing d2 from the first stop member 1071 to the central fixing portion 1131 being equal to the spacing d1 from the second stop member 1072 to the linkage assembly 1133, the spacing d2 from the first stop member 1071 to the central fixing portion 1131 being greater than the spacing d1 from the second stop member 1072 to the linkage assembly 1133 can provide sufficient vibration space for the vibration transmission sheet 113 to vibrate during normal operation, thereby enhancing the sound quality of the earphone 100.

It should be understood that in a natural state, the second stop member 1072 and the linkage assembly 1133 may be spaced apart from each other or may abut against each other. Since the linkage assembly 1133 is relatively weak in rigidity and is susceptible to stretching, the second stop member 1072 and the linkage assembly 1133 abutting against each other in the natural state can further limit the vibration degree of the vibration transmission sheet 113 and better protect the linkage assembly 1133.

Optionally, the spacing d2 from the first stop member 1071 to the central fixing portion 1131 is greater than or equal to 0.1 mm, which can make the first stop member 1071 more sensitive against the vibration transmission sheet 113 and provide timely protection. In other words, the bone-conducting loudspeaker 11 can achieve bone conduction relatively well while being less prone to damage during drops or collisions.

Considering that the spacing d1 from the second stop member 1072 to the linkage assembly 1133 is smaller than the spacing d2 from the first stop member 1071 to the central fixing portion 1131, if the second stop member 1072 is too close to the first stop member 1071 (the central fixing portion 1131), this may limit the movable distance of the magnet assembly 112 (i.e., the range of relative movement between the voice coil assembly 111 and the magnet assembly 112). Optionally, along an extension direction of the linkage assembly 1133, the position of the second stop member 1072 abutting against the linkage assembly 1133 is closer to the annular fixing portion 1132 as compared to the central fixing portion 1131. In this way, the vibration degree of the central fixing portion 1131 can be retained to a certain extent, which allows the voice coil assembly 111 and the magnet assembly 112 of the bone-conducting loudspeaker 11 to have a larger range of relative movement within a reasonable limit.

As described previously, the outer end surface 1103 of the second one of the voice coil assembly 111 and the magnet assembly 112 includes the center region 1104 and the peripheral region 1106 surrounding the center region 1104 (refer to FIG. 7 and FIG. 8 for illustrations). The center region 1104 is provided with the protrusion portion 1105. The protrusion portion 1105 protrudes with respect to the peripheral region 1106. The central fixing portion 1131 is connected to the protrusion portion 1105. In this case, it is advantageous for the second one of the voice coil assembly 111 and the magnet assembly 112 and the central fixing portion 1131 to be assembled together.

Taking the outer end surface 1103 disposed on the magnet assembly 112 as an example, the outer end surface 1103 includes the center region 1104 and the peripheral region 1106. By disposing the protrusion portion 1105 on the outer end surface 1103 of the magnet assembly 112, and fixedly connecting the central fixing portion 1131 of the vibration transmission sheet 113 to the protrusion portion 1105, on the one hand, this configuration minimizes the fixed connection region between the vibration transmission sheet 113 and the magnet assembly 112, reducing the limitations on the elastic deformation of the vibration transmission sheet 113 and improving the vibration effect while ensuring the elastic constraint, on the other hand, by not disposing the protrusion portion 1105 on the vibration transmission sheet 113, the weight of the vibration transmission sheet 113 can be kept at a certain level to reduce its impact on the vibration. At the same time, this design allows for a more reliable and stable connection between the magnet assembly 112 and the vibration transmission sheet 113.

Specifically, when the central fixing portion 1131 of the vibration transmission sheet 113 is rounded, the protrusion portion 1105 may also be cylindrical. The shape of the center region 1104 can be designed to match the shape of the central fixing portion 1131, ensuring that a stable connection is formed between the center region 1104 and the central fixing portion 1131 of the vibration transmission sheet 113.

Optionally, as shown in FIG. 17, the shell assembly 10 includes the shell 101 and the shell 102 that fit with each other along the central axis direction Z. The stop member 107 is provided on an inner surface of the shell 101 and/or an inner surface of the shell 102. The outer surface of the shell 101 and/or the outer surface of the shell 102 is in contact with the user's skin. The assembly of the bone-conducting loudspeaker 11 is facilitated by the above structure.

Optionally, the first one of the voice coil assembly 111 and the magnet assembly 112 surrounds the second one of the voice coil assembly 111 and the magnet assembly 112. For example, the voice coil assembly 111 surrounds the magnet assembly 112. The voice coil assembly 111 is rigidly connected to the shell 101 and/or the shell 102. By setting the voice coil assembly 111 surrounding the magnet assembly 112, it can minimize the magnet assembly 112, which can reduce the volume of the bone-conducting loudspeaker 11, and thus reduce the volume of the earphone 100. In other embodiments, the magnet assembly 112 may also be provided outside the voice coil assembly 111.

Optionally, the shell 102 further presses and fixes the voice coil assembly 111 to the shell 101, so that the voice coil assembly 111 can be stably sandwiched between the shell 101 and the shell 102 with a better fixing effect, and thus enhancing the effect of vibration conduction to the shell assembly 10 and easily assembling the bone-conducting loudspeaker 11 in the shell assembly 10.

As shown in FIG. 17, the core assembly 1 may include the shell assembly 10 and the microphone assembly 13. The shell assembly 10 may be provided with the accommodation cavity 1001 (more descriptions of the accommodation cavity 1001 can be found in FIG. 3, FIG. 4, etc., and the related descriptions thereof). The microphone assembly 13 may be accommodated in the accommodation cavity 1001. As shown in FIG. 17, the sound inlet hole 1082 is arranged on the shell assembly 10, and the microphone assembly 13 may be used to capture an external sound input through the sound inlet hole 1082. It is worth noting that the following description takes an electronic device as the earphone 100 as an example, and the improvement schemes such as the microphone assembly 13 and the matching structure of the microphone assembly 13 and the shell assembly 10 are applicable to other electronic devices, such as other devices with communication functions or sound collection functions, such as walkie-talkies, notebooks, conference equipment, mobile phones, tablet computers, smart wearable devices, etc.

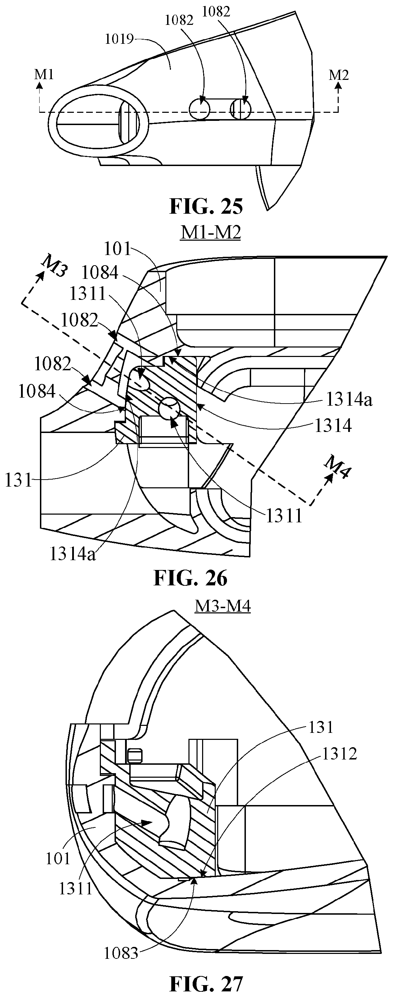

Referring to FIG. 25, FIG. 26, and FIG. 27, optionally, at least two sound inlet holes 1082 may be arranged on the shell assembly 10. Sound inlet ends of the two sound inlet holes 1082 may be spaced apart from each other, and sound outlet ends of the two sound inlet holes 1082 may be connected to each other. The sound inlet end of the sound inlet hole 1082 refers to an end where the external sound enters the sound inlet hole 1082, i.e., an end connected to the outside world. The sound outlet end of the sound inlet hole 1082 refers to an end where the external sound flows out after passing through the sound inlet hole 1082, i.e., an end extending into the shell assembly 10.

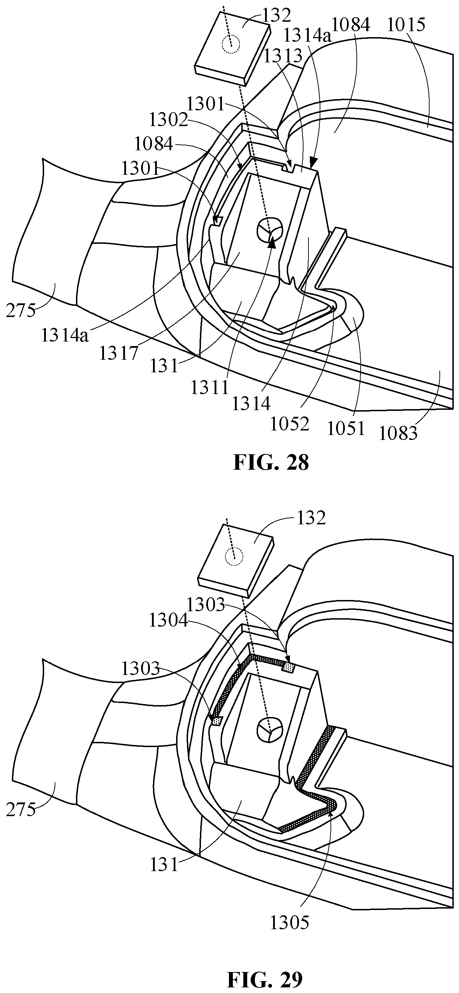

As shown in FIG. 28, the microphone assembly 13 may include a support base 131 and a microphone 132. As shown in FIG. 26 to FIG. 31, a sound guiding channel 1311 may be provided on the support base 131. As shown in FIG. 26, a sound inlet end of the sound guiding channel 1311 may be connected to the sound outlet ends of the two sound inlet holes 1082. The microphone 132 may be provided at a sound outlet end of the sound guiding channel 1311. The sound inlet end of the sound guiding channel 1311 refers to the end where the external sound enters the sound guiding channel 1311 after passing through the sound inlet holes 1082. The sound outlet end of the sound guiding channel 1311 refers to the end where the external sound flows out through the sound inlet holes 1082 and the sound guiding channel 1311.

In this case, the sound may enter the microphone assembly 13 in the accommodation cavity 1001 through the two sound inlet holes 1082 to improve the sound pickup effect of the microphone assembly 13. In addition, during the sound pickup process, there may be a large airflow entering the sound inlet holes 1082, and the airflow may enter the shell assembly 10 through one of the sound inlet holes 1082 and flow out through another sound inlet hole 1082, which can slow down the airflow speed and reduce the probability of the airflow impacting the microphone 132 through the sound guiding channel 1311, thereby reducing the wind noise during sound pickup.

Referring to FIG. 27, optionally, the sound guiding channel 1311 is provided in a bent shape. In this case, the length of the sound guiding channel 1311 can be increased, the airflow speed can be slowed down, and the influence of wind noise can be reduced.

Optionally, the length of the sound guiding channel 1311 is set to be greater than or equal to 3 mm and less than or equal to 20 mm. The length of the sound guiding channel 1311 refers to the length of the sound guiding channel 1311 along the extension direction of the sound guiding channel 1311. In this case, the airflow speed can be slowed down, and the volume of the support base 131 can be reasonably controlled.

Optionally, the support base 131 may be fixedly arranged in the shell assembly 10. For example, the support base 131 may be fixed in the shell assembly 10 by laser welding or ultrasonic welding. For example, the support base 131 is fixed in the shell assembly 10 by laser welding, and a gap between the support base 131 and the shell assembly 10 can be sealed. Specifically, the gap around the sound inlet hole 1082 and between the support base 131 and the shell assembly 10 can be sealed by laser welding, so that the airflow entering through the sound inlet hole 1082 cannot enter the accommodation cavity 1001 through the support base 131 and the shell assembly 10. For example, the support base 131 can be transparent, so that when laser welding is performed, the contact or fixed position of the support base 131 and the shell assembly 10 can be clearly observed, thereby improving the welding efficiency. When sealing is required, the path of laser welding can be clearly known, thereby effectively ensuring the sealing performance. It should be appreciated that the shell assembly 10 and the support base 131 may also be fixed by laser welding, and the shell assembly 10 or the support base 131 may be further sealed by a sealing rubber ring or a sealant. More information about sealing the shell assembly 10 and the support base 131 with a sealing rubber ring (which can be called a sealing ring) or a sealant can be found in the following description.

Referring to FIG. 28, FIG. 29, and FIG. 30, optionally, the shell assembly 10 is provided with a support surface 1083 and an abutting surface 1084. The support base 131 may be provided with a bottom surface 1312 and a top surface 1313 that are arranged opposite to each other, and at least two side surfaces 1314 connected between the bottom surface 1312 and the top surface 1313. The bottom surface 1312 of the support base 131 may be supported on the support surface 1083. A predetermined side surface 1314a among the at least two side surfaces 1314 may abut against the abutting surface 1084.

Optionally, as shown in FIG. 26 to FIG. 28, the sound outlet end of the sound inlet hole 1082 may be located on the abutting surface 1084. The sound inlet end of the sound guiding channel 1311 may be located on the predetermined side surface 1314a. The sound outlet end of the sound guiding channel 1311 may be located on the top surface 1313. The sound guiding channel 1311 may be configured to further extend inclinedly to the top surface 1313 after extending inclinedly from the predetermined side surface 1314a to the bottom surface 1312. Generally, the wall thickness of the shell assembly 10 is thin, so it is difficult to open a longer sound guiding channel 1311 on the shell assembly 10. The sound guiding channel 1311 is opened on the support base 131, which is conducive to increasing the length of the sound guiding channel 1311. Moreover, the sound inlet end and the sound outlet end of the sound guiding channel 1311 are oriented in different directions, which is conducive to slowing down the airflow speed, thereby reducing the impact of wind noise. In addition, in order to effectively slow down the airflow speed flowing in the sound guiding channel 1311, the structure of the sound guiding channel 1311 may be relatively complex, which may also increase the difficulty of processing the shell assembly 10. However, when the sound inlet hole 1082 is opened in the shell assembly 10, and the sound guiding channel 1311 is opened in the support base 131, it is conducive to reducing the processing difficulty of the shell assembly 10 and the support base 131.

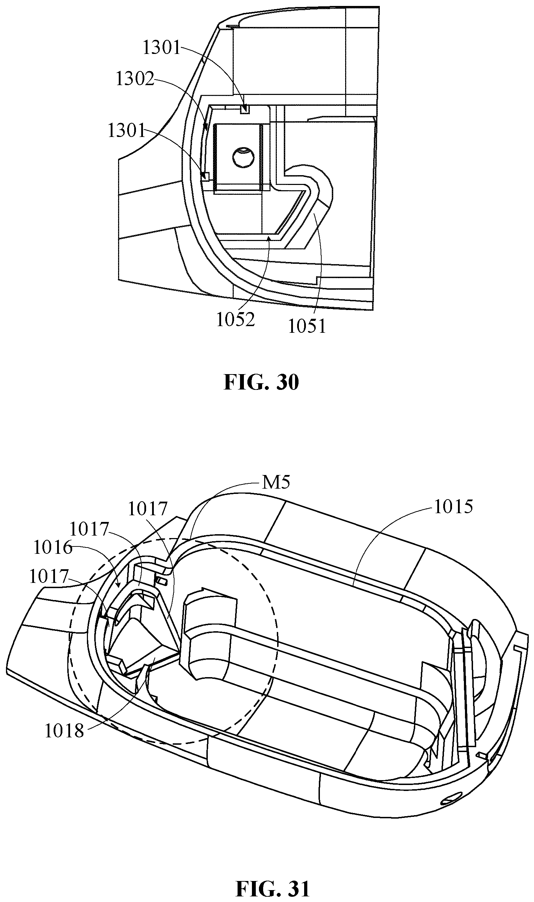

As shown in FIG. 28 and FIG. 30, optionally, two first adhesive-accommodation grooves 1301 spaced apart from each other are provided on the abutting surface 1084 and/or the predetermined side surface 1314a. The two first adhesive-accommodation grooves 1301 may connect the top surface 1313 and the bottom surface 1312 of the support base 131. The sound outlet end of the sound inlet hole 1082 and the sound inlet end of the sound guiding channel 1311 may be located between the two first adhesive-accommodation grooves 1301.

Referring to FIG. 29, optionally, the earphone 100 further includes a first sealant 1303, a second sealant 1304, and a third sealant 1305. The first sealant 1303 may seal the two first adhesive-accommodation grooves 1301. The second sealant 1304 may at least seal a gap between the top surface 1313 and the abutting surface 1084 located between the two first adhesive-accommodation grooves 1301. The third sealant 1305 may seal a gap between side surfaces 1314 among the at least two side surfaces 1314 other than the predetermined side surface 1314a and the support surface 1083.

The two first adhesive-accommodation grooves 1301 are sealed by the first sealant 1303, which can reduce the possibility of water vapor in the sound inlet hole 1082 and the sound guiding channel 1311 entering the interior of the shell assembly 10 from between the predetermined side surface 1314a and the abutting surface 1084 and from the direction perpendicular to the first adhesive-accommodation groove 1301.

When the gap between the top surface 1313 and the abutting surface 1084 located between the two first adhesive-accommodation grooves 1301 is sealed by the second sealant 1304, the possibility of water vapor entering the interior of the shell assembly 10 from between the predetermined side surface 1314a and the abutting surface 1084 and along the direction of the first adhesive-accommodation grooves 1301 can be reduced.

When the gap between the side surfaces 1314 among the at least two side surfaces 1314 other than the predetermined side surface 1314a and the support surface 1083 is sealed by the third sealant 1305, the possibility of water vapor entering the interior of the shell assembly 10 from between the support surface 1083 and the bottom surface 1312 of the support base 131 can be reduced.

That is to say, the first sealant 1303, the second sealant 1304, and the third sealant 1305 can isolate the interior of the shell assembly 10 from the sound inlet hole 1082/sound guiding channel 1311, so as to reduce the possibility that the water vapor in the sound inlet hole 1082/sound guiding channel 1311 enters the interior of the shell assembly 10 and causes electronic components (such as the microphone 132) inside the shell assembly 10 to be damp.

Optionally, a junction between the predetermined side surface 1314a and the top surface 1313 is provided as a beveled connection (referring to FIG. 28 and FIG. 30), and then fits with the abutting surface 1084 to form a second adhesive-accommodation groove 1302. The second adhesive-accommodation groove 1302 connects the two first adhesive-accommodation grooves 1301. The second sealant 1304 seals the second adhesive-accommodation groove 1302. In this case, the second adhesive-accommodation groove 1302 can conveniently and stably store the second sealant 1304, so that the second sealant 1304 can play a relatively stable sealing role. Specifically, a chamfering processing (such as beveling, rounding, or L-shaped cutting, etc.) may be performed on the junction between the predetermined side surface 1314a and the top surface 1313, so that the junction between the predetermined side surface 1314a and the top surface 1313 is provided as a beveled connection.

In other examples, the junction between the predetermined side surface 1314a and the top surface 1313 may also be provided as a stepped shape.

Optionally, referring to FIG. 28 to FIG. 30, the shell assembly 10 further includes a convex rib 1051 disposed on a periphery of the side surfaces 1314 among the at least two side surfaces 1314 other than the predetermined side surface 1314a and protruding from the support surface 1083. The convex rib 1051 and the side surfaces 1314 may fit to form a third adhesive-accommodation groove 1052. The third sealant 1305 may seal the third adhesive-accommodation groove 1052. In this case, the third adhesive-accommodation groove 1052 can conveniently and stably store the third sealant 1305, so that the third sealant 1305 can play a sealing role stably.

Optionally, the support surface 1083 and the abutting surface 1084 may be located on the shell 101. In addition, referring to FIG. 31, a support flange 1015 may also be provided on the shell 101. The support flange 1015 may be used to support the shell 102.

Optionally, referring to FIG. 31 to FIG. 35, a notch 1016 is provided on the support flange 1015. On a side close to the abutting surface 1084, a portion of the support base 131 is embedded in the notch 1016 and supports the shell 102 together with the support flange 1015.

**In** this case, when the shell 102 is assembled to the shell 101, a space for fixing the support base 131 can be formed with the notch 1016 of the shell 101, thereby fixing the support base 131.

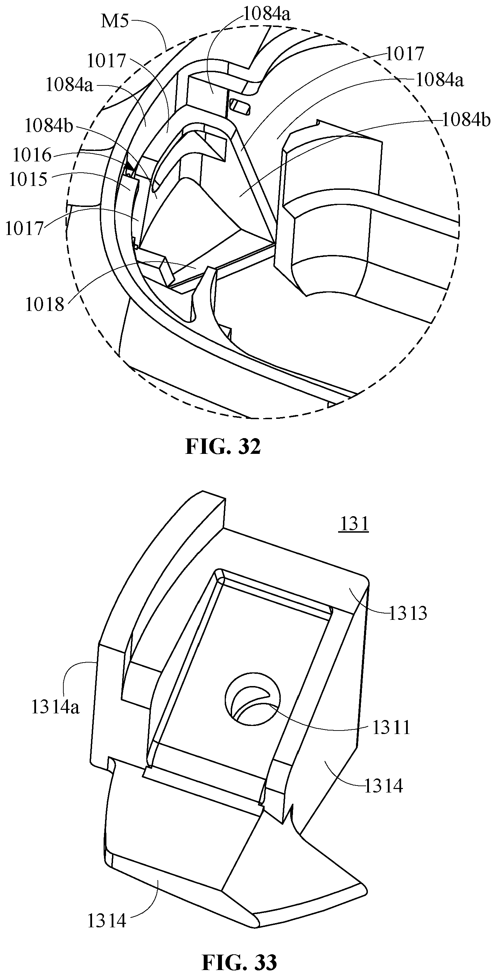

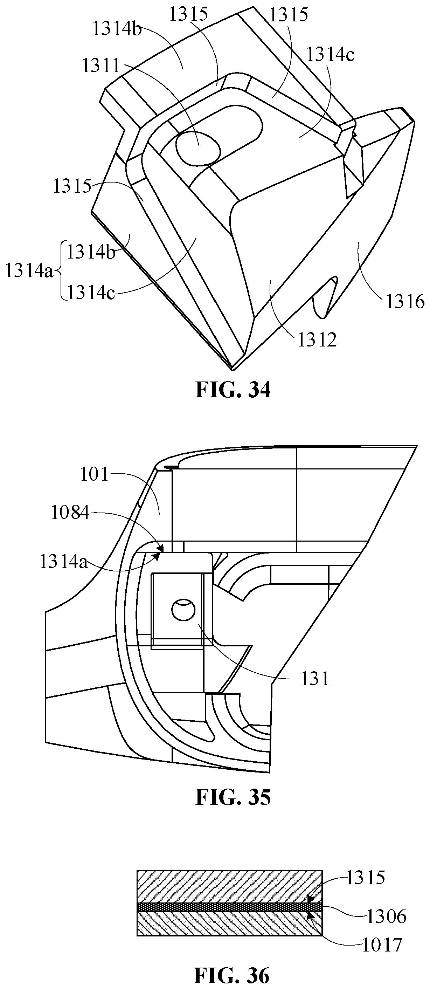

Optionally, referring to FIG. 31 and FIG. 32, a first adhesive-bearing surface 1017 connected to the abutting surface 1084 is also provided on the shell 101. Referring to FIG. 33 and FIG. 34, the first adhesive-bearing surface 1017 may be arranged to intersect with the abutting surface 1084. The support base 131 may also be provided with a second adhesive-bearing surface 1315 connected to the predetermined side surface 1314a. The second adhesive-bearing surface 1315 may be arranged to intersect with the predetermined side surface 1314a. The first adhesive-bearing surface 1017 and the second adhesive-bearing surface 1315 may overlap at least partially.

Specifically, the first adhesive-bearing surface 1017 may be perpendicular to the abutting surface 1084, or the first adhesive-bearing surface 1017 may be inclined relative to the abutting surface 1084. The second adhesive-bearing surface 1315 may be perpendicular to the predetermined side surface 1314a, or the second adhesive-bearing surface 1315 may be inclined relative to the predetermined side surface 1314a.

Referring to FIG. 32, the abutting surface 1084 may include a first abutting surface 1084a and a second abutting surface 1084b. The first abutting surface 1084a and the second abutting surface 1084b may not be coplanar. For example, the first abutting surface 1084a may be parallel to the second abutting surface 1084b. The first abutting surface 1084a may be closer to the outside of the shell assembly 10 than the second abutting surface 1084b, i.e., the first abutting surface 1084a may be arranged in a direction farther away from the support base 131. The first adhesive-bearing surface 1017 may connect the first abutting surface 1084a and the second abutting surface 1084b, and the three may be arranged in a stepped shape. An upper side of the first adhesive-bearing surface 1017 may form the notch 1016 of the shell 101.

Correspondingly, the predetermined side surface 1314a may include a first predetermined side surface 1314b and a second predetermined side surface 1314c. The first predetermined side surface 1314b and the second predetermined side surface 1314c may not be coplanar. For example, the first predetermined side surface 1314b may be parallel to the second predetermined side surface 1314c. The first predetermined side surface 1314b may protrude from the second predetermined side surface 1314c. The second adhesive-bearing surface 1315 may connect the first predetermined side surface 1314b and the second predetermined side surface 1314c, which can be arranged in a stepped shape to fit the stepped structure formed by the abutting surface 1084 and the first adhesive-bearing surface 1017.

When a portion of the support base 131 is embedded in the notch 1016, the first predetermined side surface 1314b may overlap at least partially with the first abutting surface 1084a, the first adhesive-bearing surface 1017 may overlap at least partially with the second adhesive-bearing surface 1315, and the second predetermined side surface 1314c may overlap at least partially with the second abutting surface 1084b. The overlapping herein refers to the two surfaces (such as the first predetermined side surface 1314b and the first abutting surface 1084a) arranged in an overlapping manner may fit each other, or may face each other and there is a gap between the two. It should be appreciated that even if the first predetermined side surface 1314b and the first abutting surface 1084a fit together, there may still be a gap between the first predetermined side surface 1314b and the first abutting surface 1084a that allows water vapor to pass through.

Referring to FIG. 36, optionally, the earphone 100 further includes a fourth sealant 1306. The fourth sealant 1306 may seal a gap between the first adhesive-bearing surface 1017 and the second adhesive-bearing surface 1315. **In** this case, when the fourth sealant 1306 seals the gap between the first adhesive-bearing surface 1017 and the second adhesive-bearing surface 1315, the possibility of water vapor entering the sound inlet hole 1082 and the sound guiding channel 1311 from between the predetermined side surface 1314a and the abutting surface 1084 and then entering the interior of the shell assembly 10 can be reduced.

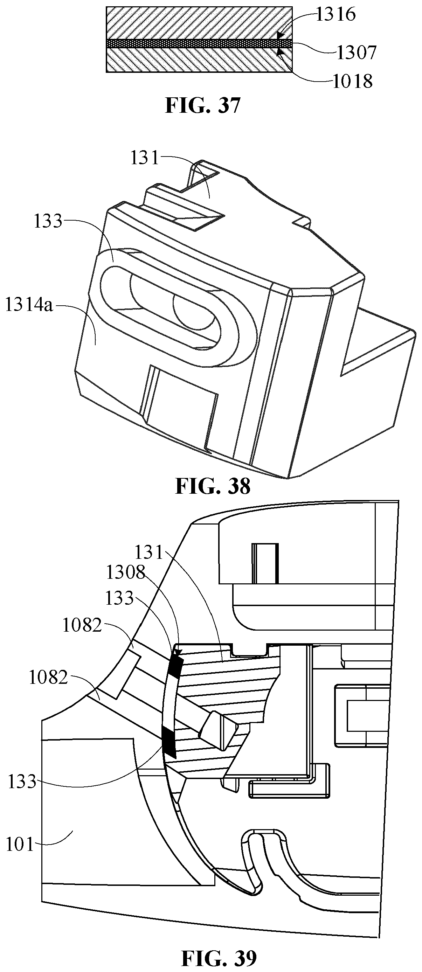

Referring to FIG. 37, optionally, the support surface 1083 includes a third adhesive-bearing surface 1018. The bottom surface 1312 includes a fourth adhesive-bearing surface 1316. The third adhesive-bearing surface 1018 and the fourth adhesive-bearing surface 1316 are at least partially overlapped. The electronic device may further include a fifth sealant 1307. The fifth sealant 1307 may seal a gap between the third adhesive-bearing surface 1018 and the fourth adhesive-bearing surface 1316. In this case, when the fifth sealant 1307 seals the gap between the third adhesive-bearing surface 1018 and the fourth adhesive-bearing surface 1316, the possibility of water vapor entering the interior of the shell assembly 10 from the gap between the support surface 1083 of the shell 101 and the bottom surface 1312 of the support base 131 can be reduced. In this case, the sealing ring 133 can reduce the possibility of water vapor from the sound inlet hole 1082 and the sound guiding channel 1311 entering the interior of the shell assembly 10 from between the predetermined side surface 1314a and the abutting surface 1084. In some embodiments of the present disclosure, the sealing ring 133 may be a rubber ring or a silicone ring, foam, etc. It should be appreciated that in some other embodiments of the present disclosure, the sealing ring 133 may also be a ring structure formed by the solidification of adhesive, i.e., the adhesive is bonded between the abutting surface 1084 and the predetermined side surface 1314a, and surrounds the periphery of the sound outlet end of the sound inlet hole 1082 and the periphery of the sound inlet end of the sound guiding channel 1311, thereby achieving the fixation of the support base 131 in the shell 10 and reducing the possibility of water vapor from the sound inlet hole 1082 and the sound guiding channel 1311 entering the interior of the shell assembly 10 from between the predetermined side surface 1314a and the abutting surface 1084.

Optionally, as shown in FIG. 39, the abutting surface 1084 is provided with a recessed region 1308 surrounding the sound outlet end of the sound inlet hole 1082. The sealing ring 133 is at least partially disposed in the recessed region 1308. Alternatively, the predetermined side surface 1314a is provided with the recessed region 1308 surrounding the sound inlet end of the sound guiding channel 1311, and the sealing ring 133 is at least partially disposed in the recessed region 1308. Such a setting can facilitate the positioning and fixing of the sealing ring 133 on the one hand, and the sealing ring 133 can further enhance the sealing effect of the sealing ring 133 in cooperation with the recessed region 1308 on the other hand.

Optionally, as shown in FIG. 28, the top surface 1313 is provided with a positioning groove 1317. The sound outlet end of the sound guiding channel 1311 is located in the positioning groove 1317. The microphone 132 is positioned in the positioning groove 1317. In this case, the microphone 132 can be reliably and accurately carried on the bearing seat, which is conducive to the microphone 132 capturing the sound entering through the sound guiding channel 1311.

Optionally, the content is described with the electronic device being the earphone 100 as an example, and the wearing assembly 27 can be connected to the shell assembly 10. In a wearing state, the wearing assembly 27 is hung on the ear of the user to position the shell assembly 10 to contact the face of the user.

Optionally, the sound inlet end of the sound inlet hole 1082 is located on the side of the shell assembly 10 along the vertical axis of the user toward the top of the user's head, and is blocked by the shell assembly 10 or the wearing assembly 27 along the sagittal axis of the user. That is, the sound inlet end of the sound inlet hole 1082 may be located on the upper rear side of the shell assembly 10. In this case, the sound inlet end of the sound inlet hole 1082 may be opened in a relatively hidden region in the shell assembly 10, blocked by the shell assembly 10 or the wearing assembly 27, thereby increasing the difficulty of external airflow entering the sound inlet hole 1082, thereby reducing wind noise.

It should be noted that in the fields of medicine, anatomy, or the like, three basic sections including a sagittal plane, a coronal plane, and a horizontal plane of the human body may be defined, respectively, and three basic axes including a sagittal axis, a coronal axis, and a vertical axis may also be defined. As used herein, the sagittal plane refers to a section perpendicular to the ground along a front and rear direction of the body, which divides the human body into left and right parts. The coronal plane refers to a section perpendicular to the ground along a left and right direction of the body, which divides the human body into front and rear parts. The horizontal plane refers to a section parallel to the ground along an up-and-down direction of the body, which divides the human body into upper and lower parts. Correspondingly, the sagittal axis refers to an axis along the front-and-rear direction of the body and perpendicular to the coronal plane. The coronal axis refers to an axis along the left-and-right direction of the body and perpendicular to the sagittal plane. The vertical axis refers to an axis along the up-and-down direction of the body and perpendicular to the horizontal plane.

For users, in most scenarios, users move forward, which means that when wearing the earphone 100, the airflow mainly comes from the front of the user (the earphone 100). Therefore, by setting the sound inlet end at the rear of the shell assembly 10, most of the airflow from the front of the user can be blocked by the shell assembly 10, and it is not easy to enter the sound inlet hole 1082. In addition, the auricle of the ear may have a sound gathering effect, which reduces the quality of the sound collected by the microphone 132. Therefore, setting the sound inlet end on an upper side of the shell assembly 10, for example, setting the sound inlet end on the side of the shell assembly 10 close to the wearing assembly 27 (the seam between the wearing assembly 27 and the shell assembly 10 is located on the upper side of the shell assembly 10), can reduce the influence of the sound gathering effect of the auricle.

Optionally, as shown in FIG. 17, the shell 101 may be provided with a first matching portion 1019. The wearing assembly 27 is provided with a second matching portion 275. The first matching portion 1019 is matched and connected with the second matching portion 275. The sound inlet hole 1082 is provided on the shell 101. The first matching portion 1019 and/or the second matching portion 275 protrude from the sound inlet end of the sound inlet hole 1082 along the vertical axis. The sound inlet end of the sound inlet hole 1082 is located at a side of the first matching portion 1019 and/or the second matching portion 275 toward the back of the human head along the sagittal axis. In this case, when the user wears the earphone 100, the shell assembly 10 may be used to prevent the airflow from the front of the user from entering the sound inlet hole 1082.

Optionally, a spacing distance between the sound inlet end of the sound inlet hole 1082 and the first matching portion 1019 and/or the second matching portion 275 along the sagittal axis is less than or equal to one-half of a maximum dimension of the shell 101 along the sagittal axis.

Optionally, the spacing distance between the sound inlet end of the sound inlet hole 1082 and the first matching portion 1019 and/or the second matching portion 275 along the sagittal axis is less than or equal to 5 mm.

Optionally, the sound inlet ends of the two sound inlet holes 1082 are spaced along the sagittal axis.

Optionally, a ratio of a distance between the sound inlet ends of the two sound inlet holes 1082 and an aperture of one of the two sound inlet holes 1082 is in a range of 0.5 to 3.

Optionally, on the sagittal axis, the sound guiding channel 1311 further includes an extension component toward the front of the user. In this case, the curvature of the sound guiding channel 1311 can be further increased, thereby slowing down the flow of airflow in the sound guiding channel 1311. In addition, the sound guiding channel 1311 includes extension components in all directions, which can increase the length of the sound guiding channel 1311 when the support base 131 is small in dimension.

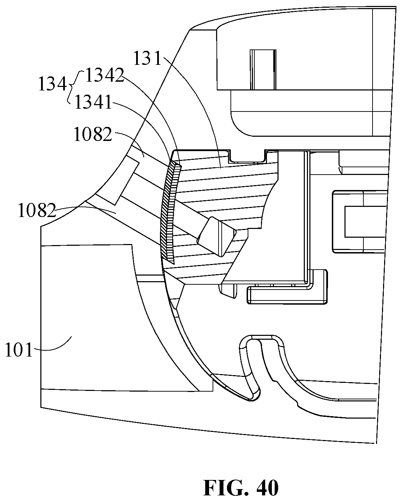

Optionally, as shown in FIG. 40, the electronic device (such as the earphone 100) may further include a tuning mesh assembly 134, which can be located in front of the microphone 132 in the sound pickup path from the sound inlet hole 1082 to the microphone 132, so that the sound entering the microphone 132 can be more uniform, and the tuning mesh assembly 134 can reduce the airflow speed and the vortex phenomenon generated by the airflow, thereby effectively reducing wind noise and improving the purity of the picked up signal. The tuning mesh assembly 134 may include at least two tuning elements 1341 and 1342. **In** order to achieve the good tuning effect, each of the at least two tuning elements, i.e., the tuning element 1341 (1342) may be arranged at the at least one of the following positions: (1) arranged between the shell assembly 10 and the support base 131, specifically arranged between the sound inlet end of the sound guiding channel 1311 and the sound outlet ends of the two sound inlet holes 1082; (2) arranged in front of the sound inlet ends of the sound inlet holes 1082, specifically in front of the sound inlet ends of the sound inlet holes 1082 and away from the sound outlet ends of the sound inlet holes 1082; (3) arranged between the support base 131 and the microphone 132, specifically arranged between the sound outlet end of the sound guiding channel 1311 and the microphone 132; (4) arranged in the sound guiding channel 1311; and (5) arranged in the sound inlet holes 1082, specifically in the sound inlet ends or the sound outlet ends of the sound inlet holes 1082. The at least two tuning elements 1341 may be arranged at the same position or at different positions.

For the tuning element 1341 and the tuning element 1342 of the tuning mesh assembly 134 to be arranged at the same position, in some embodiments, the tuning mesh assembly 134 may be arranged at the position (4) as described above, that is, arranged in the sound guiding channel 1311. In some embodiments, the tuning mesh assembly 134 may be arranged at the position (1) as described above, that is, arranged between the shell assembly 10 and the support base 131. In some embodiments, the tuning mesh assembly 134 may be arranged at the position (2) as described above, that is, in front of the sound inlet ends of the sound inlet holes 1082. In some embodiments, the tuning mesh assembly 134 may be arranged at the position (3) as described above, that is, between the support base 131 and the microphone 132. In some embodiments, the tuning mesh assembly 134 may be arranged at the position (5) as described above, that is, arranged in the sound inlet holes 1082.

For the tuning element 1341 and the tuning element 1342 of the tuning mesh assembly 134 being arranged at different positions, in some embodiments, one of the tuning element 1341 and the tuning element 1342 may be arranged at the position (4), i.e., arranged in the sound guiding channel 1311, and another one of the tuning element 1341 and the tuning element 1342 may be arranged outside the sound guiding channel 1311. For example, the tuning element 1341 and the tuning element 1342 are arranged outside the sound guiding channel 1311, but at different positions. For being arranged outside the sound guiding channel 1311, such as the position (1), i.e., the tuning element 1341 and the tuning element 1342 may be arranged between the shell assembly 10 and the support base 131, or such as the position (2), i.e., the tuning element 1341 and the tuning element 1342 may be arranged in front of the sound inlet ends of the sound inlet holes 1082, or such as the position (3), i.e., the tuning element 1341 and the tuning element 1342 may be arranged between the support base 131 and the microphone 132.

For example, a steel mesh may be used as the tuning element 1341, and a gauze mesh may be used as the tuning element 1342. **In** the tuning mesh assembly 134, a count of the steel mesh 1341 and a count of the gauze mesh 1342 may be at least one, respectively, and the specific count of the steel mesh 1341 and the specific count of the gauze mesh 1342 can be the same or different. At least one steel mesh 1341 and at least one gauze mesh 1342 may be stacked and arranged at the same position. Optionally, along the direction from the outside to the inside of the shell assembly 10, the stacking order of the at least one steel mesh 1341 and the at least one gauze mesh 1342 may be not limited, and the at least one steel mesh 1341 and the at least one gauze mesh 1342 may also be separated from each other and arranged at different positions.

For the above positions, FIG. 40 only shows that the tuning mesh assembly 134 is arranged at the position (1) as described, that is, the tuning mesh assembly 134 is arranged between the shell assembly 10 and the support base 131, and other embodiments are not shown in the figures. Referring to FIG. 40, FIG. 29, etc., and the descriptions of the above-mentioned embodiments, the setting position of the tuning mesh assembly 134 can be clearly defined without any doubt, and the drawings of other embodiments are not shown here.

The foregoing is only a part of the embodiments of the present disclosure, and is not intended to limit the scope of protection of the present disclosure, and any equivalent device or equivalent process transformations utilizing the contents of the present disclosure and the accompanying drawings, or applying them directly or indirectly in other related technical fields, are similarly included in the scope of patent protection of the present disclosure.

## Claims

1. An electronic device, comprising:
a shell assembly, the shell assembly being provided with an accommodation cavity and two sound inlet holes; and
a microphone assembly accommodated in the accommodation cavity, the microphone assembly being configured to capture an external sound input via the two sound inlet holes, wherein
sound inlet ends of the two sound inlet holes are spaced apart from each other,
sound outlet ends of the two sound inlet holes are in communication with each other, and
the microphone assembly includes a support base and a microphone, the support base being provided with a sound guiding channel, a sound inlet end of the sound guiding channel being in communication with the sound outlet ends of the two sound inlet holes, the microphone being provided at a sound outlet end of the sound guiding channel.

2. The electronic device of claim 1, wherein the sound guiding channel is provided in a bent shape.

3. The electronic device of claim 2, wherein a length of the sound guiding channel is greater than or equal to 3 mm and less than or equal to 20 mm.

4. The electronic device of claim 1, wherein the shell assembly is provided with a support surface and an abutting surface,
the sound outlet ends of the two sound inlet holes are on the abutting surface, and
the support base is provided with a bottom surface and a top surface that are arranged opposite to each other and at least two side surfaces connected between the bottom surface and the top surface,
the bottom surface of the support base is supported on the support surface,
a predetermined side surface among the at least two side surfaces abuts against the abutting surface,
the sound inlet end of the sound guiding channel is located on the predetermined side surface,
the sound outlet end of the sound guiding channel is located on the top surface, and
the sound guiding channel is configured to further extend inclinedly towards the top surface after extending inclinedly from the predetermined side surface towards the bottom surface.

5. The electronic device of claim 4, wherein the abutting surface and/or the predetermined side surface is provided with two first adhesive-accommodation grooves spaced apart from each other,
the two first adhesive-accommodation grooves connect the top surface to the bottom surface of the support base,
the sound outlet ends of the two sound inlet holes and the sound inlet end of the sound guiding channel are located between the two first adhesive-accommodation grooves, and
the electronic device further comprises a first sealant, a second sealant and a third sealant, wherein
the first sealant seals the two first adhesive-accommodation grooves,
the second sealant at least seals a gap between the top surface and the abutting surface located between the two first adhesive-accommodation grooves, and
the third sealant seals a gap between the support surface and any other side surface among the at least two side surfaces other than the predetermined side surface.

6. The electronic device of claim 5, wherein a junction between the predetermined side surface and the top surface is provided as a beveled connection, and the junction further fits with the abutting surface to form a second adhesive-accommodation groove, wherein the second adhesive-accommodation groove connects the two first adhesive-accommodation grooves, and the second sealant seals the second adhesive-accommodation groove.

7. The electronic device of claim 6, wherein the shell assembly further includes a convex rib disposed around a periphery of the other side surfaces among the at least two side surfaces other than the predetermined side surface and protruding from the support surface,
the convex rib fits with the other side surfaces among the at least two side surfaces other than the predetermined side surface to form a third adhesive-accommodation groove, and
the third sealant seals the third adhesive-accommodation groove.

8. The electronic device of claim 4, wherein the shell assembly includes a first shell and a second shell,
the support surface and the abutting surface are located on the first shell,
the first shell is provided with a support flange,
the support flange is configured to support the second shell,
the support flange is provided with a notch, and
on a side proximate to the abutting surface, a portion of the support base is embedded in the notch and supports the second shell together with the support flange.

9. The electronic device of claim 8, wherein the first shell is further provided with a first adhesive-bearing surface connected to the abutting surface,
the first adhesive-bearing surface intersects with the abutting surface,
the support base is further provided with a second adhesive-bearing surface connected to the predetermined side surface,
the second adhesive-bearing surface intersects with the predetermined side surface, and
the first adhesive-bearing surface and the second adhesive-bearing surface are at least partially overlapped, wherein
the electronic device further comprises a fourth sealant, and the fourth sealant seals a gap between the first adhesive-bearing surface and the second adhesive-bearing surface.

10. The electronic device of claim 9, wherein the support surface includes a third adhesive-bearing surface,
the bottom surface includes a fourth adhesive-bearing surface, and
the third adhesive-bearing surface and the fourth adhesive-bearing surface are at least partially overlapped, wherein
the electronic device further includes a fifth sealant, and the fifth sealant seals a gap between the third adhesive-bearing surface and the fourth adhesive-bearing surface.

11. The electronic device of claim 4, further comprising a sealing ring, wherein
the sealing ring is elastically sandwiched between the abutting surface and the predetermined side surface, and
the sealing ring is disposed around an outer periphery of the sound outlet ends of the two sound inlet holes and the sound inlet end of the sound guiding channel.

12. The electronic device of claim 11, wherein the abutting surface is provided with a recessed region surrounding the sound outlet ends of the two sound inlet holes, and the sealing ring is located in the recessed region; or
the predetermined side surface is provided with a recessed region surrounding the sound inlet end of the sound guiding channel, and the sealing ring is located in the recessed region.

13. The electronic device of claim 4, wherein the top surface is provided with a positioning groove, the sound outlet end of the sound guiding channel is located in the positioning groove, and the microphone is positioned in the positioning groove.

14. The electronic device of any one of claims 1 to 13, wherein the electronic device is an earphone and includes a wearing assembly, wherein
the wearing assembly is connected to the shell assembly,
in a wearing state, the wearing assembly is hung on an ear of a user to enable the shell assembly to be in contact with a face of the user, and
the sound inlet ends of the two sound inlet holes are located on a side of the shell assembly along a vertical axis of the user towards the top of the user's head, and are blocked by the shell assembly or the wearing assembly along a sagittal axis of the user.

15. The electronic device of claim 14, wherein the shell assembly includes a first shell,
the first shell is provided with a first matching portion,
the wearing assembly is provided with a second matching portion,
the first matching portion is matched and connected with the second matching portion,
the two sound inlet holes are provided on the first shell,
the first matching portion and/or the second matching portion protrude from the sound inlet ends of the two sound inlet holes along the vertical axis, and
the sound inlet ends of the two sound inlet holes are located on a side of the first matching portion and/or the second matching portion towards the back of the user's head along the sagittal axis.

16. The electronic device of claim 15, wherein a spacing distance between a sound inlet end of one of the two sound inlet holes and the first matching portion and/or the second matching portion along the sagittal axis is less than or equal to one-half of a maximum dimension of the first shell along the sagittal axis.

17. The electronic device of claim 15, wherein a spacing distance between a sound inlet end of one of the two sound inlet holes and the first matching portion and/or the second matching portion along the sagittal axis is less than or equal to 5 mm.

18. The electronic device of claim 15, wherein the sound inlet ends of the two sound inlet holes are spaced apart along the sagittal axis.

19. The electronic device of claim 15, wherein a ratio of a spacing distance between the sound inlet ends of the two sound inlet holes to an aperture of one of the two sound inlet holes is in a range of 0.5 and 3.

20. The electronic device of claim 15, wherein on the sagittal axis, the sound guiding channel further includes an extension component towards a front side of the user.

21. The electronic device of claim 1, wherein the support base is fixed to the shell assembly by laser welding.

22. The electronic device of claim 1, comprising a tuning mesh assembly, wherein
the tuning mesh assembly is located in front of the microphone in a sound pickup path from any one of the two sound inlet holes to the microphone, and
the tuning mesh assembly includes at least two tuning elements, wherein
each of the at least two tuning elements is located between the shell assembly and the support base, or located in front of a sound inlet end of one of the two sound inlet holes, or located between the support base and the microphone, or located in the sound guiding channel, or located in one of the two sound inlet holes.
